# EUROPEAN PATENT APPLICATION

(11) **EP 4 597 123 A2**
(43) Date of publication of application: **06.08.2025**
(21) Application number: 25150132.6
(22) Date of filing: 03.01.2025
(51) Int. Cl.: G01R 27/02, G01R 27/16, G01R 27/18, G01R 31/12, G01R 31/40, G01R 31/52

(54) **INSULATION DETECTION CIRCUIT AND INSULATION DETECTION METHOD**

(30) Priority: 05.01.2024 CN 202410021376
(71) Applicant: Delta Electronics (Shanghai) Co., Ltd., Shanghai 201209 (CN)
(72) Inventor: MA, Peng, Shanghai, 201209 (CN); XIE, Yicong, Shanghai, 201209 (CN); LOU, Junshan, Shanghai, 201209 (CN); ZHANG, Weiqiang, Shanghai, 201209 (CN)
(74) Representative: SSM Sandmair

(57) **Abstract**

The application discloses an insulation detection circuit (100-1, 100-2) and an insulation detection method. The insulation detection circuit (100-1, 100-2) includes a power conversion circuit (10) including a power module, the power module (11) including an input end, an output end and a voltage jump point (N1, N2, N3; NA1, NA2, NA3, NB1, NB2, NB3; NC1, NC2, NC3); a detection circuit (20) including a detection impedance, a first end of the detection circuit (20) electrically connected to the input end or the output end of the power module, a second end of the detection circuit (20) electrically connected to a reference point (N_{REF}); an input power source (30) electrically connected to the power conversion circuit (10); and an insulation detection unit for obtaining a voltage or a current of the detection circuit (20), and detecting an insulation state of the power conversion circuit (10) relative to the reference point (N_{REF}), or detecting an insulation state of the voltage jump point (N1, N2, N3; NA1, NA2, NA3, NB1, NB2, NB3; NC1, NC2, NC3) of the power module (11) relative to the reference point (N_{REF}).

## Description

### BACKGROUND OF THE APPLICATION

### 1. Field of the Application

The application relates to the field of power electronic technology, and particularly to an insulation detection circuit and an insulation detection method.

### 2. Related Art

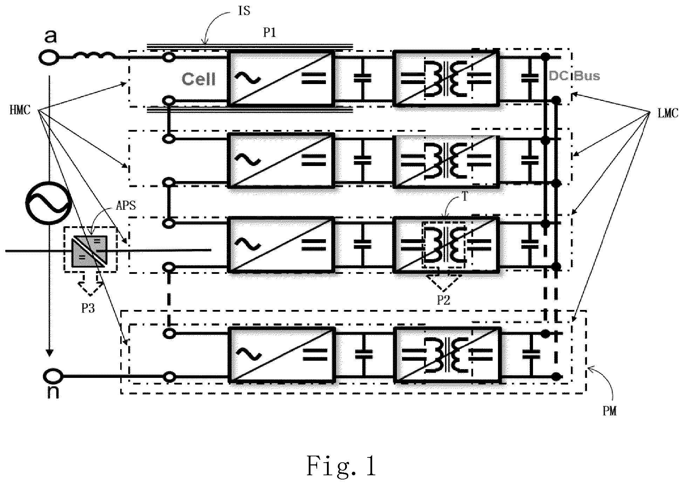

Solid state transformer (SST) is development direction of the future data center and powering of the charging pile due to advantages of high efficiency and modularization. As shown in FIG. 1, it shows a structure of the existing medium-voltage SST system. The SST system has an input side for receiving a medium-voltage AC input voltage (for example, an input voltage is 10kV, 13.8kV or 20kV), and an output side for outputting a low-voltage DC voltage (for example, an output voltage is 1kV). The SST system is consisting of a plurality of power modules PM cascaded, for example, illustratively showing four power modules PM cascaded between an input node a and an input node n of FIG. 1, but it can be understood that the number of power modules PM is not limited thereto. As for each power module PM, it includes a transformer T, a high-voltage module circuit (HMC) at a high side of the transformer T, and a low-voltage module circuit (LMC) at a low side of the transformer T. The high-voltage module circuit (HMC) includes a two-stage conversion circuit, which is an AC/DC conversion circuit at a preceding stage and a DC/DC conversion circuit at a subsequent stage.

As shown in FIG. 1, the position having insulation requirement in the whole SST system mainly includes: insulation between different phases, insulation between different power modules (such as, insulation between housings of the power modules at a position P1), insulation between high- and low-voltage module circuits and insulation between primary and secondary sides of a high-frequency transformer (shown at a position P2), and insulation (shown at a position P3) between an auxiliary powering medium voltage (MV) side of an auxiliary power source (APS) and a safety extra low voltage (SELV) of the mains supply.

The traditional scheme is to process insulation at the three positions, respectively. For example, the position P1 is isolated using the way of an insulation plate or a shielding insulation housing, the position P2 is isolated using the way of insulation sealing a high-voltage coil, and the position P3 is isolated using the way of a high-voltage silicone wire and an air compound insulation. The scheme of designing such insulation will cause increase of the number of parts in the system, and reduce reliability of insulation of the system.

In order to reduce complexity of the system, and increase reliability of insulation of the system, currently, some schemes are to share one shielding insulation housing at the three positions for insulating isolation. For example, the power modules are formed of modules and an insulation housing, and one module is formed of the high- and low-voltage module circuits and the high-frequency transformer, and is isolated using the insulation housing IS of FIG. 1. The insulation housing IS is formed of a high-voltage shielding conductive surface, a low-voltage shielding conductive surface and a middle solid insulation layer.

Although these schemes have improved reliability of insulation of the system to the maximum extent from the perspective of design of the system, but in actual running process, the equipment still shall face a series of factors or conditions for accelerating deterioration of insulation property such as a high electric field stress, hot and cold cycles, mechanical vibration, even environmental chemical pollution, and the like, which affect true insulation life of the equipment. Therefore, it is quite necessary to monitor an insulation state of the system, which can detect change of the insulation state of the equipment in advance, remind operation and maintenance staff to timely adopt the corresponding measures, and avoid huge loss brought by power failure due to fault of the equipment.

Currently, the method of monitoring an insulation state of the equipment can be mainly divided into the following types:
(1) the state monitoring method based on partial discharge mainly has a pulse current method, a RF detection method, an ultra-high frequency method, a transient earth voltage detection method and an ultrasonic method. Partial discharge refers to a phenomenon that discharge occurs in only a part of areas of the insulation system of the equipment, and does not penetrate the insulation between the conductors where a voltage is applied, i.e., breakdown does not occur, wherein discharge occurring on an insulation surface refers to surface partial discharge, and discharge occurring inside refers to internal partial discharge. Principle of such method is to reflect the insulation state of the equipment by measuring physical changes such as pulse currents, electromagnetic waves and sound waves produced by partial discharge of the insulation part. Advantages of such method are 1) capable of sensitively detecting partial defects in the insulation; 2) capable of locating defective positions using the ultra-high frequency method and the ultrasonic method. However, difficulties of such method are that 1) measurement signals are susceptible to interference from on-site noise; 2) how to obtain information of the insulation state from the partial discharge signal is a problem to be urgently solved.
(2) the state monitoring method based on frequency domain dielectric spectrum mainly has an electric bridge method and a voltmeter ammeter method. The frequency domain dielectric spectrum method mainly reflects the degree of insulation aging by monitoring change of a dielectric loss factor angle, uses a voltage transformer and a current transformer to sample a voltage value of the electrical system and a leakage current signal flowing to the ground, respectively, and obtains a phase difference between them through calculation and analysis processing to test the dielectric loss factor angle. Advantage of such method is capable of sensitivity reflecting the case of whole insulation aging of the equipment (e.g., affected by moisture, etc.). Difficulty of such method is that the dielectric loss factor angle only reflects the whole aging information of the equipment, cannot sensitivity reflect local defective information of the insulation, and cannot locate the defective position.
(3) the state monitoring method based on a leakage current mainly has a DC superposition method, an AC superposition method and a common-mode path method. Such method mainly reflects change of the insulation state of the equipment by monitoring change of a current flowing the insulation under voltage excitation. Advantages of such method are to: 1) have the characteristic of non-invasive installation without off-line monitoring or changing a topological structure of the system; 2) under certain voltage excitation, calculate an insulation resistance from an earth leakage current, which visually reflect an insulation state of the electrical system. However, currently, such method has the following challenges, 1) requiring a professional equipment to excite and sample in a way of DC or AC superposed injection, 2) the measuring circuit is complex, and how to perform real-time monitoring and fault location of the insulation state of the electrical system simply and reliability at a low cost is a difficulty.

Therefore, how to provide a device or method that can sensitively reflect or monitor the insulation state of each power module without additionally adding a measuring device becomes one of the problems to be urgently solved in the industry.

### SUMMARY OF THE APPLICATION

An object of the application is to provide an insulation detection circuit and an insulation detection method, which can effectively solve at least one deficiency in the prior art.

In order to achieve the object, the application provides an insulation detection circuit, including: a power conversion circuit including a power module, the power module including an input end, an output end and a voltage jump point; a detection circuit comprising a detection impedance, a first end of the detection circuit electrically connected to the input end or the output end of the power module, a second end of the detection circuit electrically connected to a reference point; an input power source electrically connected to the power conversion circuit; and an insulation detection unit for obtaining a voltage or a current of the detection circuit, and detecting an insulation state of the power conversion circuit relative to the reference point, or detecting an insulation state of the voltage jump point of the power module relative to the reference point.

In order to achieve the object, the application provides an insulation detection method applied to the insulation detection circuit, the insulation detection method configured for detecting the insulation state of the power conversion circuit relative to the reference point, including:
determining a first voltage threshold according to the maximum voltage amplitude of the detection circuit;
obtaining a real-time voltage amplitude of the detection circuit, and comparing the real-time voltage amplitude of the detection circuit with the first voltage threshold;
when the real-time voltage amplitude of the detection circuit is less than the first voltage threshold, determining that the insulation state of the power conversion circuit relative to the reference point is an insulation failure state;
when the real-time voltage amplitude of the detection circuit is greater than or equal to the first voltage threshold, determining that the the insulation state of the power conversion circuit relative to the reference point is an insulation normal state.

In order to achieve the object, the application further provides an insulation detection method applied to the insulation detection circuit, the insulation detection method configured for detecting the insulation state of the voltage jump point of each one of the plurality of the power modules relative to the reference point, and including:
obtaining a real-time voltage amplitude of the detection circuit and a real-time voltage phase of the detection circuit;
querying a first table preset in the insulation detection unit, determining the insulation state of the voltage jump point of each one of the plurality of the power modules relative to the reference point.

In order to achieve the object, the application further provides an insulation detection method applied to the insulation detection circuit, the insulation detection method configured for detecting the insulation state of the three power conversion circuits relative to the reference point, and including:
determining a third voltage threshold according to a maximum voltage amplitude of the three input power sources;
obtaining a real-time voltage amplitude of each one of the three detection circuit;
obtaining a maximum difference in differences between the real-time voltage amplitudes of any two of the three detection circuits;
comparing the maximum difference with the third voltage threshold;
when the maximum difference is less than or equal to the third voltage threshold, determining that the insulation state of each one of the three power conversion circuits relative to the reference point is an insulation normal state;
when the maximum difference is greater than the third voltage threshold, determining that the insulation state of at least one of the three power conversion circuits relative to the reference point is an insulation failure state.

In order to achieve the object, the application further provides an insulation detection method applied to the insulation detection circuit, at least one of the three power conversion circuits includes a plurality of the power modules connected in series;
when the insulation state of the at least one of the three power conversion circuits relative to the reference point is an insulation failure state, the insulation detection method configured for detecting the insulation state of the voltage jump point of each one of the plurality of the power modules within the at least one of the three power conversion circuits relative to the reference point, and including:
obtaining a real-time voltage amplitude and a real-time voltage phase of the detection circuit corresponding to the at least one of the three power conversion circuits;
querying a second table preset in the insulation detection unit, determining the insulation state of the voltage jump point of each one of the plurality of the power modules within the at least one of the three power conversion circuits relative to the reference point.

In order to achieve the object, the application further provides an insulation detection method applied to the insulation detection circuit, and at least one of the three power conversion circuits includes a plurality of the power modules connected in series;
when the insulation state of the at least one of the three power conversions relative to the reference point is an insulation failure state, the insulation detection method configured for detecting an insulation state of the voltage jump point of each one of the plurality of the power modules within the at least one of the three power conversion circuits relative to the reference point, and including:
obtaining a normal voltage amplitude of the voltage jump point of each one of the plurality of the power modules within the at least one of the three power conversion circuits when the insulation state of the three power conversion circuits relative to the reference point is an insulation normal state;
obtaining a real-time voltage amplitude of the voltage jump point of each one of the plurality of the power modules within the at least one of the three power conversion circuits;
calculating a voltage amplitude reduction ratio of the voltage jump point of each one of the plurality of the power modules within the at least one of the three power conversion circuits, wherein the voltage jump point corresponding to the power module of the maximum voltage amplitude reduction ratio is in the insulation failure state relative to the reference point.

Through the device and method of the application, it is unnecessary to additionally add a measuring device, and can also sensitively reflect or monitor the insulation state of each power module. In some embodiments, position of the failed module and information of the insulation resistance are obtained through the device and method of the application.

Additional aspects and advantages of the application are partially explained in the below description, and partially become apparent from the description, or can be obtained from practice of the application.

### BRIEF DESCRIPTION OF THE DRAWINGS

Exemplary embodiments are described in details with reference to the accompanying drawings, and the above and other features and advantages of the application become more apparent.
FIG. 1 is a schematic diagram of formation of the prior SST system.
FIG. 2 is a schematic diagram of an insulation detection circuit based on a single-phase system.
FIG. 3A is a schematic diagram of a connection between the detection circuit and the power conversion circuit, wherein the power conversion circuit include one power module, and the detection circuit is electrically connected to an input end of the power module.
FIG. 3B is a schematic diagram of another connection between the detection circuit and the power conversion circuit, wherein the power conversion circuit include multiple power modules, and the detection circuit is electrically connected to a voltage jump point N3 of the power module Cell_3.
FIG. 3C is a schematic diagram of another connection between the detection circuit and the power conversion circuit, wherein the power conversion circuit include multiple power modules, and the detection circuit is electrically connected to a output end of the power module Cell_3.
FIG. 4A is a schematic diagram of a common-mode circuit model based on a three-phase system.
FIG. 4B is a schematic diagram of an equivalent model of an insulation impedance of each power module in FIG. 4A.
FIG. 4C is a schematic diagram of a simplified circuit model of FIG. 4A.
FIG. 5 is a specific flow diagram of an insulation detection method applied to the three-phase system and the single phase system.
FIG. 6 shows curves of three-phase voltage amplitudes and phases varying with an insulation resistance of a power module Cell_A3 of phase A.
FIG. 7 shows curves of voltage amplitude and phase of phase A varying with insulation resistances of different power modules within the phase A.
FIGS. 8A, 8B and 8C respectively show changes of voltage amplitude reduction ratios of the voltage jump points of all power modules Cell_A1, Cell_A2 and Cell_A3 varying with the insulation resistance of power modules Cell_A1, Cell_A2 and Cell_A3.
FIG. 9 shows curves of the voltage amplitude reduction ratios of the voltage jump points of different power modules within the phase A varying with the insulation resistance of corresponding power modules within the phase A.
FIG. 10 is a structural diagram of an insulation detection circuit grounded via an impedance, wherein three detection circuits of the insulation detection circuit and three power conversion circuits are both connected to a metallic shield housing.
FIG. 11A is a structural diagram when a detection object of the insulation detection circuit is a signal at a voltage jump point of the power module.
FIG. 11B is a schematic diagram where the detection circuit of the insulation detection circuit measures a phase voltage using a voltage-dividing resistance.
FIG. 11C is a schematic diagram where the detection circuit of the insulation detection circuit achieves electrical isolation using a transformer to measure the phase voltage.
FIG. 11D is a schematic diagram where the detection circuit of the insulation detection circuit directly measures using a current probe to obtain a current value within the detection circuit.
FIG. 12A is a structural diagram of an insulation detection circuit based on a single phase system, wherein a resistance of a detection resistor is 10MΩ.
FIG. 12B shows curves of voltage amplitudes of the power conversion circuit in FIG. 12A varying with the insulation resistances of different power modules.
FIG. 13A is a structural diagram of bypassing the power module Cell_1.
FIG. 13B shows curves of voltage amplitudes and phase of the power conversion circuit in FIG. 13A varying with the insulation resistances of different power modules.
FIG. 14A is a structural diagram of an insulation detection circuit based on a single phase system, wherein a resistance of the detection resistor is 1MΩ.
FIG. 14B shows curves of voltage amplitudes of the power conversion circuit in FIG. 14A varying with the insulation resistances of different power modules.
FIG. 15 is a deformation diagram of a topology of an insulation detection circuit based on a three-phase system.
FIG. 16 is a deformation diagram of a topology of an insulation detection circuit based on a single phase system.
FIG. 17A is a flow diagram of an insulation detection method according to an embodiment of the application.
FIG. 17B is a flow diagram of an insulation detection method according to another embodiment of the application.
FIG. 17C is a flow diagram of an insulation detection method according to another embodiment of the application.
FIG. 17D is a flow diagram of an insulation detection method according to another embodiment of the application.
FIG. 17E is a flow diagram of an insulation detection method according to another embodiment of the application.

### DETAILEDEMBODIMENTS OF THE APPLICATION

Now the exemplary embodiments are comprehensively described with reference to the accompanying drawings. However, the exemplary embodiments can be implemented in various forms, and shall not be understood to be limited to the described embodiments. On the contrary, these embodiments are provided to make the application comprehensive and complete, and concept of the exemplary embodiments is fully conveyed to those skilled in the art. The same reference signs in the drawings represent the same or similar structure, so detailed descriptions are omitted.

When introducing the described and/or illustrated elements or components or the like, the words "one", "first", "the" and "at least one" represent one or more elements or components or the like. The terms "comprise", "include" and "have" represent an open and including meaning, and refer to additional elements or components or the like, except listed elements or components or the like. The word "connection" is configured to represent direct connection or indirect connection (i.e., there are also other elements or components between the two elements or components) between the two elements or components. In addition, the terms "first", "second" and the like in the claims are only used as signs, not limit to the number of the object.

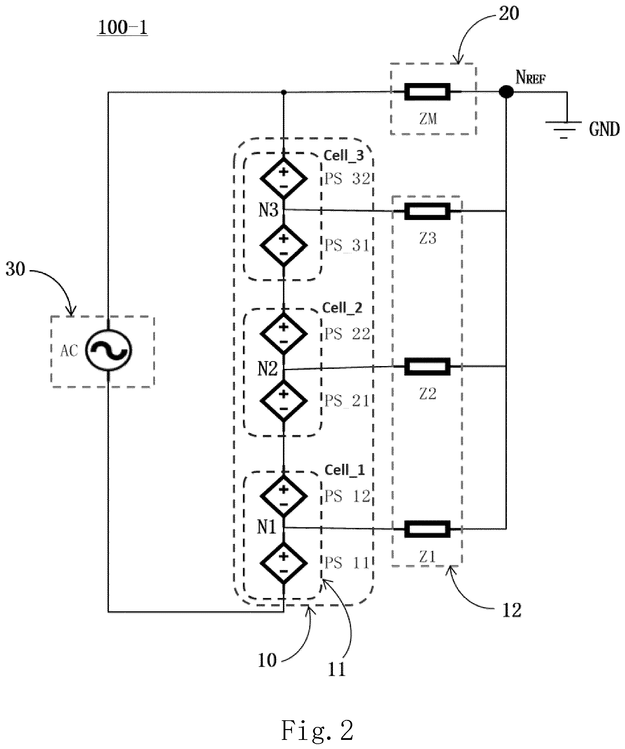

As shown in FIG. 2, it shows a structure of an insulation detection circuit 100-1 based on a single phase system according to the application. The insulation detection circuit 100-1mainly includes a power conversion circuit 10, a detection circuit 20, an input power source 30 and an insulation detection unit (not shown).

The power conversion circuit 10 includes multiple power modules 11, each including an input end, an output end and a voltage jump point. As stated previously, each power module includes an insulation housing, and the insulation housing includes a high-voltage shielding conductive surface, a low-voltage shielding conductive surface and a middle solid insulation layer. The voltage jump point of the power module indicated by the application refers to a conductive layer or a semi-conductive layer disposed on the high-voltage shielding conductive surface at an inner side of the insulation housing.

In the application, the power conversion circuit is viewed as an active network, and in the embodiment of FIG. 2, the active network includes one power conversion circuit, and forms a single phase system. In the embodiment of FIG. 2, the power conversion circuit 10 includes three power modules 11 connected in series, i.e., power modules Cell_1, Cell_2 and Cell_3. In FIG. 2, the power modules Cell_1, Cell_2 and Cell_3 have voltage jump points N1, N2 and N3, respectively. It can be understood that the number of power modules 11 included in the power conversion circuit 10 is not limited to the number in FIG. 2, i.e., the number of power modules 11 can also be one or more, but the application is not limited thereto. In the application, as for each power module 11, it includes an upper bridge arm and a lower bridge arm, the voltage jump point within each power module 11 is viewed as a midpoint located between the upper bridge arm and the lower bridge arm, and an insulation state of each power module 11 is equivalent to an insulation impedance 12 connected in series between the voltage jump point and a reference point N_{REF}. For example, in the embodiment of FIG. 2, the power module Cell_1 includes a lower bridge arm PS_11 and an upper bridge arm PS_12, and an insulation impedance Z1 is equivalently connected in series between the midpoint (i.e., the voltage jump point N1) located between the lower bridge arm PS_11 and the upper bridge arm PS_12 and the reference point N_{REF}; the power module Cell_2 includes a lower bridge arm PS_21 and an upper bridge arm PS_22, and an insulation impedance Z2 is equivalently connected in series between the midpoint (i.e., the voltage jump point N2) between the lower bridge arm PS_21 and the upper bridge arm PS_22 and the reference point N_{REF}; the power module Cell_3 includes a lower bridge arm PS_31 and an upper bridge arm PS_32, and an insulation impedance Z3 is equivalently connected in series between the midpoint (i.e., the voltage jump point N3) between the lower bridge arm PS_31 and the upper bridge arm PS_32 and the reference point N_{REF}. It shall be noticed that the insulation impedance indicated in the application is an equivalent insulation impedance between the power module and the reference point, and is configured to describe the insulation state of the power module relative to the reference point, and in practical work, an impedance electrical device is not actually connected between the power module and the reference point.

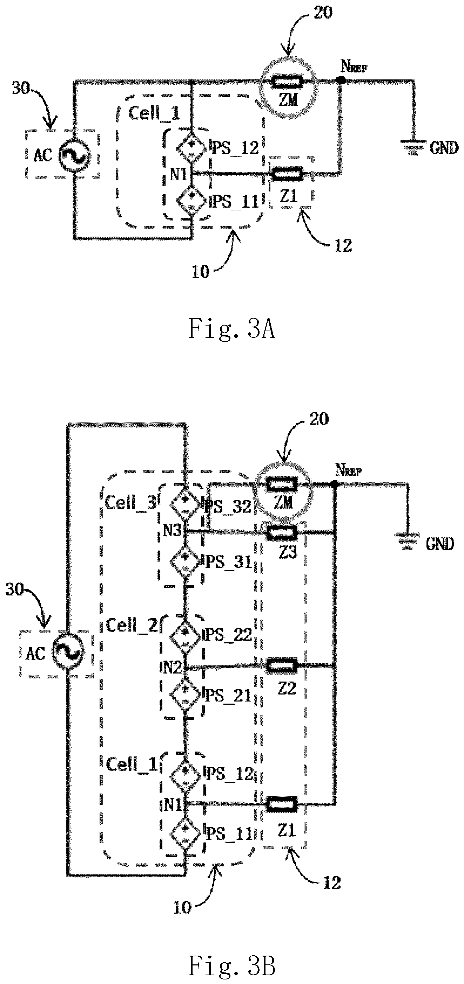

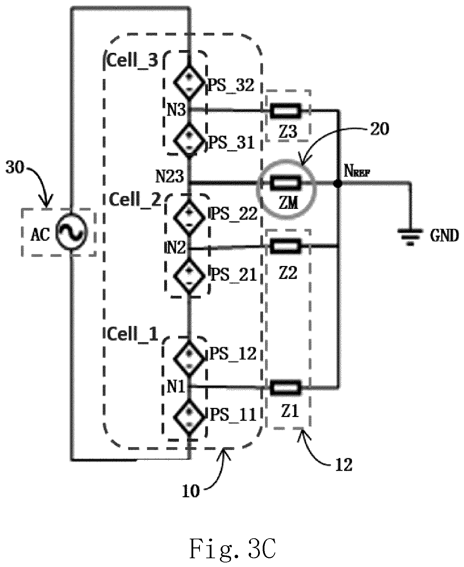

The detection circuit 20 includes a detection impedance ZM, and is configured to measure a voltage of the power conversion circuit 10. In the application, a first end of the detection circuit 20 is electrically connected to a power module 11, and a second end of the detection circuit 20 is electrically connected to a reference point N_{REF}. In the embodiment of FIG. 2, the reference point N_{REF} is grounded, but the application is not limited thereto. In the embodiment of FIG. 2, the first end of the detection circuit 20, for example, is electrically connected to the input end of the power module Cell_3, but the application is not limited thereto. It can be understood that in some embodiments, the first end of the detection circuit 20 is electrically connected to the input end or the output end of any of the power modules 11. In some specific embodiment, for example, when the power conversion circuit 10 includes a plurality of power modules 11 connected in series, the first end of the detection circuit 20 is also electrically connected to the voltage jump point of any of the power modules within the power conversion circuit 10. For example, as shown in FIG. 3A, it shows a connection between the detection circuit 20 and the power conversion circuit 10. In this embodiment, the power conversion circuit 10 includes a single module (e.g., only including the power module Cell_1), and the detection circuit 20 is electrically connected to the input end of the power module within the power conversion circuit 10. For example, a first end of the detection impedance ZM is in direct electrical connection to the input end of the power module Cell_1. As shown in FIG. 3B, it shows another connection between the detection circuit 20 and the power conversion circuit 10 in the application. In this embodiment, the power conversion circuit 10 includes a plurality of power modules (e.g., including the power modules Cell_1 to Cell_3), and the detection circuit 20 is connected in parallel to the insulation impedance of the power module relative to the reference point N_{REF}. For example, the detection impedance ZM is connected in parallel to the equivalent insulation impedance Z3 of the power module Cell_3, i.e., a first end of the detection impedance ZM is electrically connected to the voltage jump point N3 of the power module Cell_3, and a second end of the detection impedance ZM and the other end of the equivalent insulation impedance Z3 of the power module Cell_3 are together connected to the reference point N_{REF}. As shown in FIG. 3C, it shows another connection between the detection circuit 20 and the power conversion circuit 10 according to the application. In this embodiment, the power conversion circuit 10 includes a plurality of power modules (for example, including power modules Cell_1 to Cell_3), and the detection circuit 20 is connected between the two power modules of the power conversion circuit 10. For example, the first end of the detection impedance ZM is electrically connected to a output end of the power module, the output end of the power module Cell_3 is the node N23, which can be also viewed as an input end of the power module Cell_2, and the second end of the detection impedance ZM is connected to the reference point N_{REF}.

The input power source 30 is electrically connected to the power conversion circuit 10. In the embodiment of FIG. 2, the input power source 30 is an AC power source. As for the single phase system of FIG. 2, both ends of the input power source 30 are electrically connected to both ends of the power conversion circuit 10 respectively to achieve powering of the input power source 30 to the power conversion circuit 10.

The insulation detection unit (not shown) directly obtains a voltage of the power conversion circuit 10 by obtaining a voltage of the detection circuit 20, and detects an insulation state of the power conversion circuit 10 relative to the reference point N_{REF}, or detect an insulation state of the power module 11 relative to the reference point N_{REF}. In other embodiments of the application, the insulation detection unit also detect an insulation state of the power conversion circuit 10 relative to the reference point N_{REF}, or detect an insulation state of the voltage jump point of the power module 11 relative to the reference point N_{REF} by obtaining a current of the detection circuit 20.

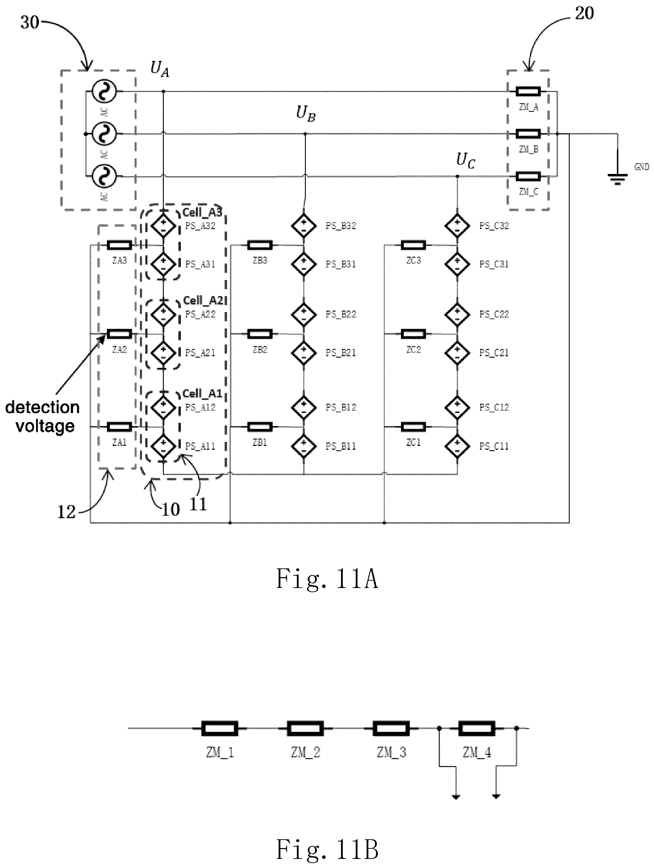

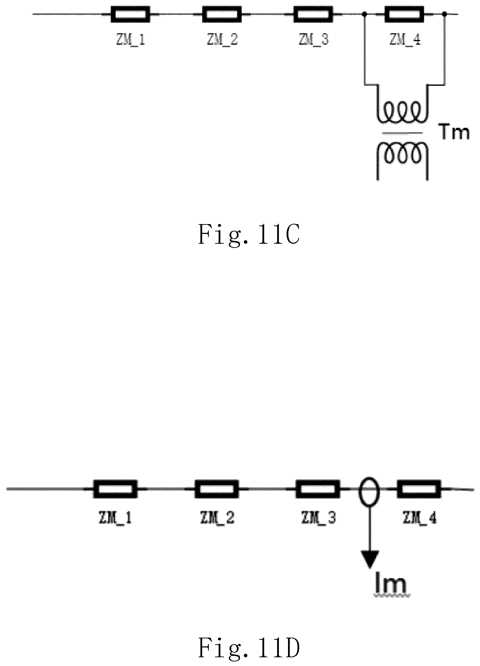

In some embodiments of the application, the detection circuit 20 includes a single detection impedance, and as shown in FIG. 2, the detection circuit 20 includes only one detection impedance ZM. However, in some embodiments, the detection circuit 20 can also include a plurality of detection impedances connected in series, and as shown in FIG. 11B, the plurality of detection impedances ZM_1, ZM_2, ZM_3 and ZM_4 connected in series form a voltage-dividing detection circuit through which a voltage class of a measurement signal processing circuit is reduced. In some additional embodiments, the detection circuit 20 further includes a transformer, and a primary winding of the transformer is connected in parallel to at least a part of the detection impedances. As shown in FIG. 11C, the plurality of detection impedances ZM_1, ZM_2, ZM_3 and ZM_4 connected in series form a voltage-dividing detection circuit, and further includes a transformer Tm, a primary winding of the transformer Tm is connected in parallel to the detection impedance ZM_4, and a voltage of the detection circuit is measured through a secondary winding of the transformer Tm. In this embodiment, electrical isolation measurement is achieved using the transformer Tm, and a safety class of a low-voltage circuit is improved.

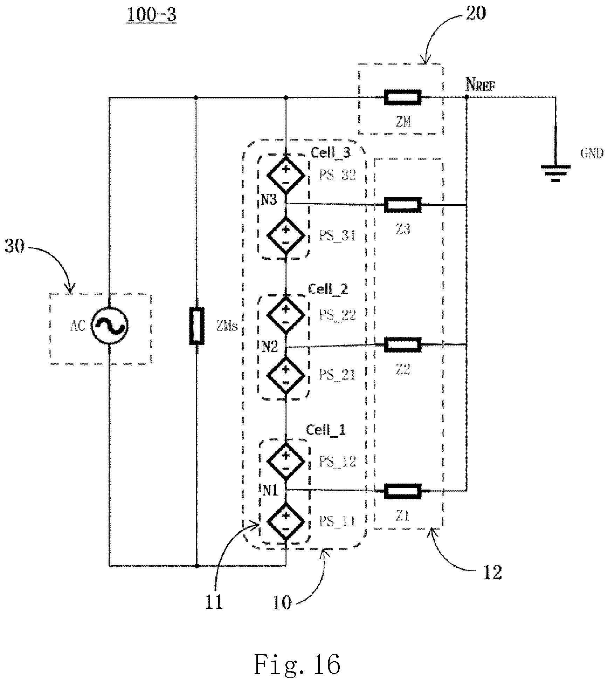

In some embodiments of the application, the input power source 30 is further connected in parallel to a power detection impedance ZMs for monitoring a voltage of the input power source, as shown in FIG. 16. By monitoring the voltage of the input power source, in the insulation detection process, influence of fluctuation of the voltage of the input power source on the insulation detection is excluded.

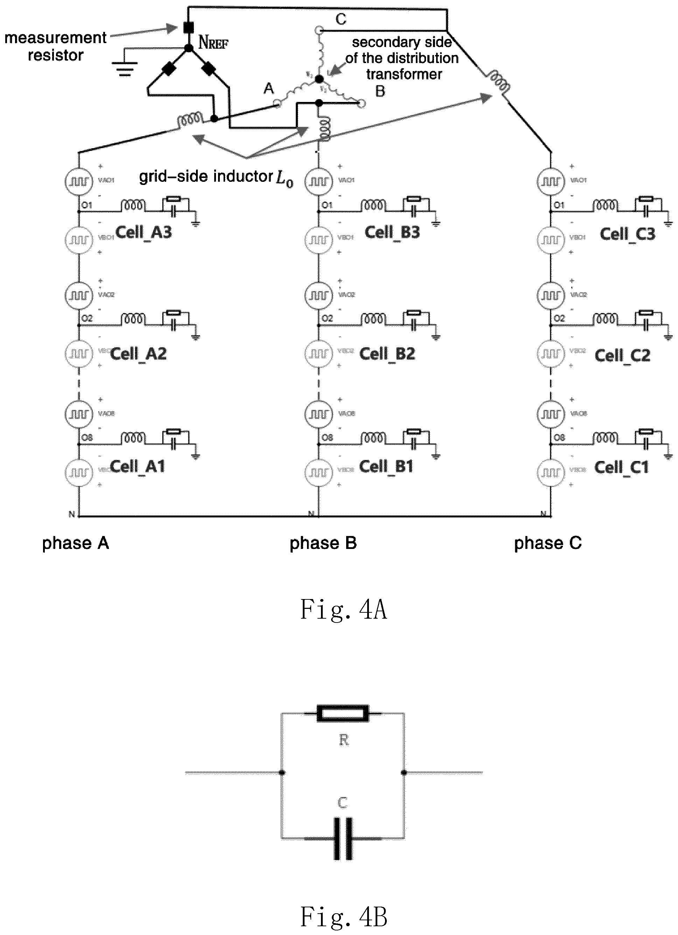

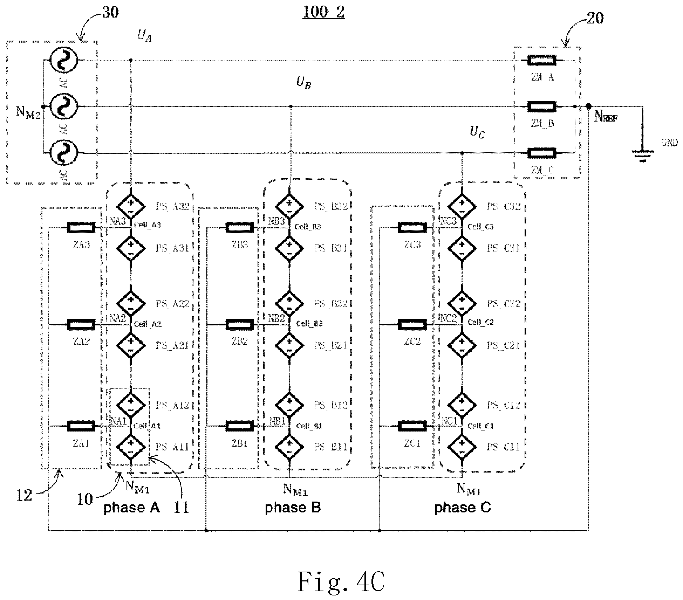

The insulation detection circuit of the application is applied to a three-phase system. FIG. 4A shows a common-mode circuit model based on a three-phase system, FIG. 4B shows an equivalent model of an insulation impedance of each power module relative to a reference point N_{REF} in FIG. 4A , and FIG. 4C shows a simplified circuit model of FIG. 4A. As shown in FIG. 4A, a secondary side (the input power source) of a transformer and the three power conversion circuits (such as, phase A, phase B and phase C) are all in a star connection. In order to measure voltages of the three power conversion circuits, the secondary side (the input power source) of the transformer lead out three measuring resistors that form a star connection as detection impedances, respectively, and midpoints of the three measuring resistors form the reference point N_{REF}. Each of the three power conversion circuits (i.e., phase A, phase B and phase C) include of a plurality of power modules cascaded, and the number of power modules within each power conversion circuit can be the same, and can also be different. FIG. 4A exemplarily explains that each power conversion circuit includes three power modules cascaded. For example, the phase A power conversion circuit includes three power modules Cell_A1, Cell_A2 and Cell_A3, the phase B power conversion circuit includes three power modules Cell_B1, Cell_B2 and Cell_B3, and the phase C power conversion circuit includes three power modules Cell_C1, Cell_C2 and Cell_C3. As for each power module, a common-mode inductor and an insulation impedance are equivalently connected in series between a midpoint (i.e., a voltage jump point) located between the upper and lower bridge arms and the ground. The insulation impedance is equivalent to a parallel connection of a capacitor C and an insulation resistance R, as shown in FIG. 4B. Assumptions are as follows: (1) the secondary side of the transformer is equivalent to a three-phase input power source, and a phase difference therebetween is 120°; (2) the SST system and the grid-side inductor are equivalent to a three-phase voltage source; (3) influence of the common-mode inductor in each power module on a power frequency voltage is omitted. Under the assumptions, it is simplified to an equivalent circuit model shown in FIG. 4C, including an insulation detection circuit 100-2.

Difference from the insulation detection circuit 100-1 based on the single phase system of FIG. 2 is that the insulation detection circuit 100-2 based on the three-phase system of FIG. 4C includes three power conversion circuits 10, three detection circuits 20 and three input power sources 30. The three power conversion circuits 10 together form an active network, and respectively form one phase of the three-phase system, such as, phase A, phase B and phase C, and one end of the three power conversion circuits 10 is electrically connected to a first neutral point N_{M1}. The three detection circuits 20 are in one-to-one correspondence with the three power conversion circuits 10. For example, the phase A detection circuit corresponds to the phase A power conversion circuit, the phase B detection circuit corresponds to the phase B power conversion circuit, the phase C detection circuit corresponds to the phase C power conversion circuit, and a voltage U_{A} of the phase A detection circuit, a voltage U_{B} of the phase B detection circuit and a voltage U_{C} of the phase C detection circuit are measured by the detection circuits 20, and are configured to determine an insulation state of the phase A power conversion circuit, the phase B power conversion circuit and the phase C power conversion circuit relative to the reference point N_{REF}, or an insulation state of the power modules within the respective power conversion circuits relative to the reference point N_{REF}. The first end of each one of the three detection circuits 20 is electrically connected to an input end or an output end of one of the power modules 11 within the corresponding power conversion circuit 10, respectively (for example, in the embodiment of FIG. 4C, electrically connected to input ends of the power modules Cell_A3, Cell_B3 and Cell_C3 within the corresponding power conversion circuit, respectively), and the second end of each one of the three detection circuits 20 is electrically connected to the reference point N_{REF}. One end of each one of the three input power sources 30 is electrically connected to a second neutral point N_{M2}, and the other end of each one of the three input power sources 30 is electrically connected to the other end of each one of the three power conversion circuits 10, respectively.

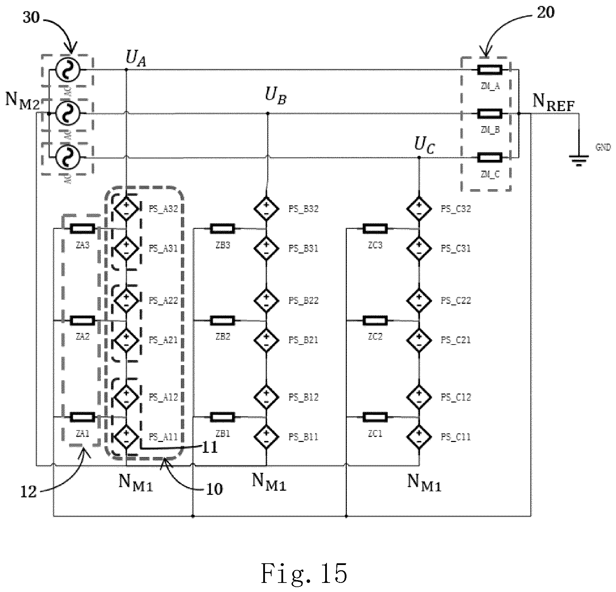

In some embodiments of the application, the first neutral point N_{M1} is electrically connected to the second neutral point N_{M2}, as shown in FIG. 15.

The insulation detection circuit of the application monitors voltages of the detection circuits 20 through the insulation detection unit, and detects an insulation state of the power conversion circuits 10 relative to the reference point, or detect an insulation state of the voltage jump points of the power modules 11 relative to the reference point. Further, it monitors insulation impedances of the voltage jump points of the power modules 11 relative to the reference point. Advantages of the insulation detection circuit of the application lie in: (1) the insulation detection circuit is formed by connection of the existing devices of the system, does not change the original topological structure of the system without additionally setting an active detection device, and largely reduces cost of the insulation detection system; (2) only by monitoring the voltages of the detection circuits, the insulation state of the power conversion circuits relative to the reference point, the insulation state of the voltage jump points of the power modules relative to the reference point, and the insulation impedances of the voltage jump points of the power modules relative to the reference point are monitored simultaneously, and the position where insulation failure occurs is located, so the whole detection circuit is simple and reliable. To facilitate explanation, hereinafter the insulation state and the insulation impedances of the voltage jump points of the power modules relative to the reference point are referred to as the insulation state and the insulation impedances of the power modules relative to the reference point.

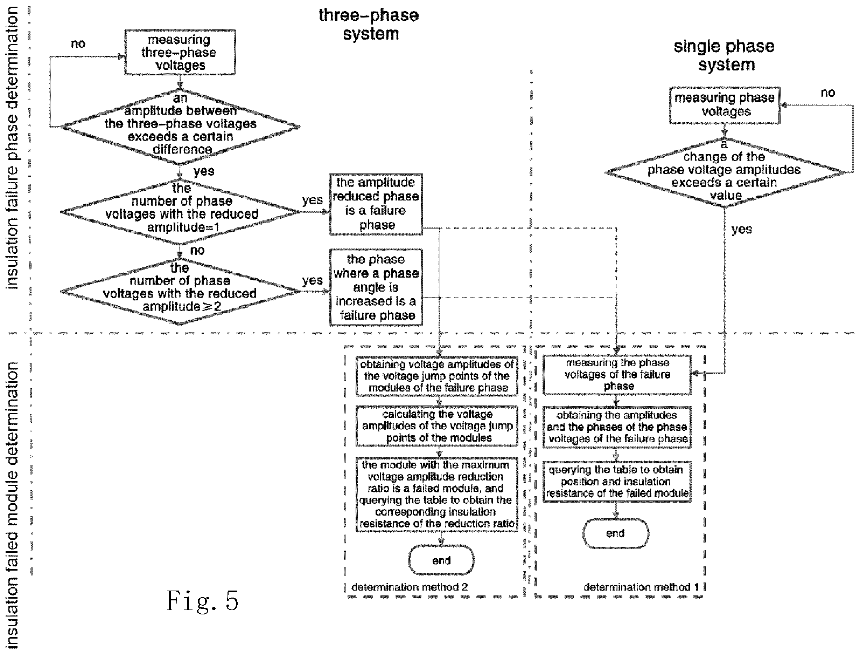

As shown in FIG. 5, it shows specific flows of an insulation detection method facing the three-phase system and the single phase system according to the application. In the application, insulation detection requirements are divided into two types: "insulation failure phase determination" and "insulation failed module determination". These two types of requirements are independent from each other, and implemented respectively.

In the application, "insulation failure phase determination" refers to determine the insulation state of each power conversion circuit relative to the reference point. As for the three-phase system (phase A, phase B and phase C) consisting of the three power conversion circuits, taking the topology of FIG. 4C for example, the insulation state of each phase power conversion circuit relative to the reference point is determined by detecting a voltage amplitude of the detection circuit corresponding to each phase power conversion circuit. For example, when a difference of voltage amplitudes of the three detection circuits corresponding to the phase A power conversion circuit, the phase B power conversion circuit and the phase C power conversion circuit exceeds a certain threshold, for example, a difference of voltage amplitudes of any two of the three detection circuits exceeds 5% of the maximum voltage amplitude of the input power source, it can be determined that the insulation state of at least one phase in the phase A power conversion circuit, the phase B power conversion circuit and the phase C power conversion circuit is insulation failure state relative to the reference point. If a real-time voltage amplitude of only one detection circuit in real-time voltage amplitudes of the three detection circuits is reduced only, it is determined that the insulation state of the power conversion circuit corresponding to the only one detection circuit where the real-time voltage amplitude is reduced is insulation failure state relative to the reference point, i.e., an insulation failure phase, and if the real-time voltage amplitudes of the two detection circuits in the real-time voltage amplitudes of the three detection circuits are reduced, it is determined that the insulation state of the power conversion circuit corresponding to the detection circuit where a phase of the real-time voltage amplitudes of the two detection circuit is increased is insulation failure state relative to the reference point, i.e., an insulation failure phase. As for the single phase system consisting of a single power conversion circuit, taking the topology of FIG. 2 for example, the insulation state of the power conversion circuit relative to the reference point is determined by detecting the real-time voltage of the detection circuit corresponding to the one power conversion circuit. When a change of the real-time voltage amplitude of the detection circuit exceeds a threshold, for example, the real-time voltage amplitude of the detection circuit is decreased to exceed 5% of the maximum voltage amplitude of the input power source, or reduced to 95% of the maximum voltage amplitude of the input power source, or 95% or less of the maximum voltage amplitude of the detection circuit, it is determined that the insulation state of the single power conversion circuit is insulation failure state relative to the reference point. Here 95% of the maximum voltage amplitude of the detection circuit is a first voltage threshold, and 5% of the maximum voltage amplitude of the input power source is a third voltage threshold.

"Insulation failed module determination" refers to a method for determining specific cascaded position of the power module where insulation failure occurs within the power conversion circuit after finding the specific power conversion circuit where insulation failure specifically occurs. Hereinafter the power conversion circuit where insulation failure occurs relative to the reference point is referred to the failure phase, and the power module where insulation failure occurs relative to the reference point is referred to a failed module. In the application, "insulation failed module determination" mainly has two determination methods:

Determination method 1: measuring and obtaining a real-time voltage amplitude and a phase of the corresponding detection circuit of the failure phase, and then obtaining the cascaded position of the failed module within the failure phase and the corresponding insulation resistance through a look-up table according to the amplitude and the phase.

Determination method 2: obtaining the real-time voltage amplitude of the voltage jump point of the respective power modules within the failure phase, calculating a reduction ratio of the real-time voltage amplitude of the voltage jump point of the respective power modules, wherein the power module of the maximum voltage amplitude reduction ratio is the failed module, and then obtaining the corresponding insulation resistance of the failed module relative to the reference point through a look-up table according to the reduction ratio of the real-time voltage amplitude of the failed module.

The determination method 1 is applicable to the three-phase system and the single phase system, and the determination method 2 is only applicable to the three-phase system.

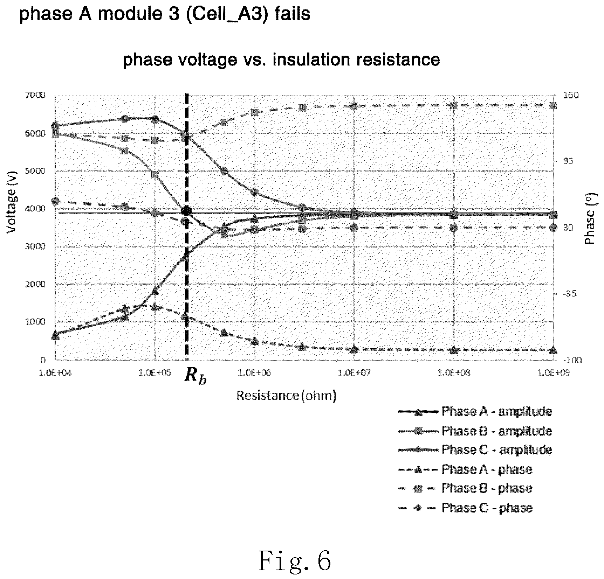

The topology in embodiment one of the application is shown in FIG. 4C, and hereinafter accuracy of the method for determining the insulation failure phase disclosed by the application is verified through the theory. As shown in FIG. 6, it shows curves of real-time voltage amplitudes and phases of the three detection circuits varying with an insulation resistance of the power module Cell_A3 of phase A when the module Cell_A3 (i.e., the power module Cell_A3) in FIG. 4C is in insulation failure state. In FIG. 6, when the real-time voltage amplitude of the phase B detection circuit is equal to the real-time voltage amplitude of the phase B input power source with good insulation, the corresponding insulation resistance of the power module Cell_A3 is a partition resistor *R_{b}*, and a dotted line at the position *R_{b}* divides the curves into left and right portions. On the right side of the dotted line, with reduction of the insulation resistance of the power module Cell_A3, the real-time voltage amplitudes of the phase A detection circuit and the phase B detection circuit are decreased, the real-time voltage amplitude of the phase C detection circuit is increased, and a phase of the real-time voltage of the corresponding detection circuit of the phase (phase A) where insulation failure exists is increased. On a left side of the dotted line, with continuous reduction of the insulation resistance of the power module Cell_A3, the real-time voltage amplitude of the phase A detection circuit is decreased, and the real-time voltage amplitudes of the phase B detection circuit and the phase C detection circuit are decreased. The curves change of the two portions shall verify validity of "insulation failure phase determination" of the three-phase system of the application.

The power conversion circuit where insulation failure occurs is determined by measuring the real-time voltage amplitudes and the phases of the three detection circuits. If insulation properties of one power conversion circuit are reduced, the real-time voltages of the three phase detection circuits have a difference, and the real-time voltages of the three phase detection circuits will be reduced or risen. In actual determining process, when a difference between the real-time voltage amplitudes of any two of the three phase detection circuits is greater than a certain threshold, for example, 5% of the maximum voltage amplitude of the input voltage, the insulation detection unit determines that the three-phase system has had insulation failure, and further determines that which specifically phase power conversion circuit is in insulation failure state. According to analyses on the real-time voltages of the three phase detection circuits, if the real-time voltage amplitude of only one phase detection circuit in the three phase detection circuits is reduced, the corresponding power conversion circuit of the detection circuit where the voltage amplitude is reduced is the failure phase, and if the real-time voltage amplitudes of the two phase detection circuits in the three phases detection circuits are reduced, the corresponding power conversion circuit of the detection circuit where a phase of the real-time voltage is increased in the two phase detection circuits where the voltage amplitudes are reduced is the failure phase.

As for the topology only including the single power conversion circuit 10 in FIG. 2, it is unnecessary to determine the failure phase, and determine whether the single power conversion circuit 10 is in insulation failure state only by measuring a change of the voltage amplitude of the corresponding detection circuit 20. When the change of the voltage amplitude of the detection circuit 20 exceeds a threshold, for example, the real-time voltage amplitude of the detection circuit is decreased to exceed 5% of the maximum voltage amplitude of the input power source, or reduced to 95% or less of the maximum voltage amplitude of the input power source, it is determined that the insulation state of the single power conversion circuit is insulation failure state relative to the reference point.

The embodiment two of the application totally has two determination methods for determining a position of the failed module where insulation failure occurs within the power conversion circuit where insulation failure occurs.

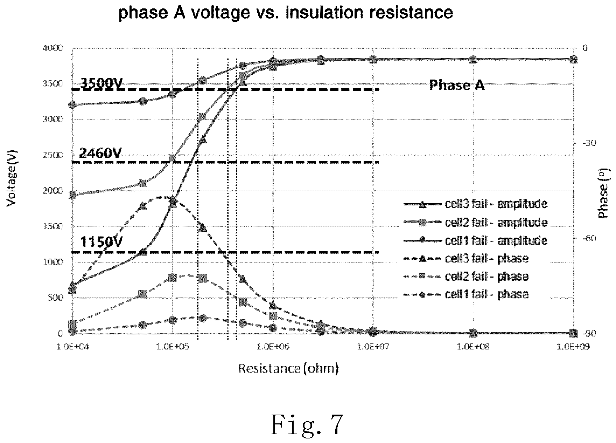

Determination method 1: determining the cascaded position of the failed module using the amplitude and the phase of the real-time voltage of the corresponding detection circuit of the failure phase. Since the method is applicable to the single phase system of FIG. 2 and the three-phase system of FIG. 4C simultaneously, it is explained taking the three-phase system of FIG. 4C for example. If the phase A in FIG. 4C is in insulation failure state, FIG. 7 shows curves of change of the phase and the amplitude of the real-time voltage of the corresponding phase A detection circuit when the insulation resistances of different power modules within the phase A relative to the reference point have change. As can be seen from FIG. 7, (1) when the insulation resistances of the power modules at different cascaded positions relative to the reference point have the same change, the degree of reduction of the real-time voltage amplitude of the corresponding phase A detection circuit is different. The closer the cascaded position of the insulation failed module to the input power source is, i.e., the larger the serial number of the failed modules Cell_A1 to Cell_A3is, the larger the degree of reduction of the real-time voltage amplitude of the phase A detection circuit will be. Meanwhile, a change of the phase of the real-time voltage of the phase A detection circuit is also different. That is, there is a mapping relation between position of the insulation failed power module and the amplitude and the phase of the real-time voltage of the phase A detection circuit, which are in one-to-one correspondence. (2) when the insulation resistance of the same power module relative to the reference point has different changes, with decrease of the insulation resistance, the amplitude of the real-time voltage of the phase A detection circuit is gradually decreased, and the phase of the real-time voltage of the phase A detection circuit is firstly increased, and then decreased. That is, there is also a mapping relation between the insulation resistance of the insulation failed power module and the amplitude and the phase of the real-time voltage of the phase A detection circuit, which are in one-to-one correspondence. Therefore, according to the mapping relations, as for the single phase system, a first table is made, and as for the three-phase system, a second table is made correspondingly. The first table includes a mapping relation between the amplitude and the phase of the real-time voltage of the single phase detection circuit 20 and the specific position and the insulation resistance of the failed module within the corresponding single power conversion circuit 10. The second table includes a mapping relation between the amplitude and the phase of the real-time voltage of the phase A detection circuit and the specific position and the insulation resistance of the failed module within the phase A. Similarly, the second table also include a mapping relation between the amplitude and the phase of the real-time voltage of the phase B detection circuit and the specific position and the insulation resistance of the failed module within the phase B, and a mapping relation between the amplitude and the phase of the real-time voltage of the phase C detection circuit and the specific position and the insulation resistance of the failed module within the phase C. Therefore, in the single phase system of FIG. 2, if the power conversion circuit 10 is in insulation failure state, the amplitude and the phase of the real-time voltage of the detection circuit 20 are obtained, and the specific position of the failed module and the insulation resistance of the failed module relative to the reference point are obtained by querying the first table. Also, in the three-phase system of FIG. 4C, when any phase in the phase A power conversion circuit, the phase B power conversion circuit and the phase C power conversion circuit is in insulation failure state, the amplitude and the phase of the real-time voltage of the corresponding detection circuit of the power conversion circuit where insulation failure occurs are obtained, and the specific position of the failed module within the failure phase and the insulation resistance of the failed module relative to the reference point are obtained by querying the second table.

The ways of querying the first table and the second table are similar, and here how to determine position of the failed module and obtain the insulation resistance by querying the second table is exemplarily introduced. Relevant contents of the second table are shown in table 1, and table 1 illustratively shows the mapping relation between the real-time voltage amplitude and the phase of the phase A detection circuit and the specific position and the insulation resistance of the failed module within the phase A. In actual insulation detection process, when the real-time voltage amplitude of the phase A detection circuit falls within the range of 3200V to 3847V, at least one power module of the three power modules within the phase A power conversion circuit is in insulation failure state, and further combining with phase information of the real-time voltage of the phase A detection circuit, the specific position and the insulation resistance of the power module where insulation failure occurs are determined. For example, if the real-time voltage amplitude of the phase A detection circuit is measured to be 3500V, and the phase to be -73°, it is determined that the power module Cell_A3 is in insulation failure state, and it is further found out that a failure insulation resistance of Cell_A3 is 500kQ; when the phase is -78°, it is determined that the power module Cell_A2 is in insulation failure state, and a failure insulation resistance is 280kQ; when the phase is -85°, it is determined that the power module Cell_A1 is in insulation failure state, and a failure insulation resistance is 200kQ. When the real-time voltage amplitude of the phase A detection circuit falls within the range of 1900V to 3200V, the possible failure position is the power module Cell_A2 and the power module Cell_A3; when the real-time voltage amplitude of the phase A detection circuit is 2460V, and the phase is -54°, it is determined that the power module Cell_A3 is in insulation failure state, and a failure insulation resistance is 130kQ; when the phase is -73°, it is determined that the power module Cell_A2 is in insulation failure state, and a failure insulation resistance is 100kS2.When the real-time voltage amplitude of the phase A detection circuit is less than 1900V, it is determined that the power module Cell_A3 is in insulation failure state. For example, if the real-time voltage amplitude of the phase A detection circuit is 1150V, the phase is -50°, and a failure insulation resistance is 50kQ.

**Table 1 Three phase voltage amplitudes and the corresponding failed modules and insulation resistances (failure phase-phase A)**

| phase A voltage amplitude | 3500V | | | 2460V | | | 1150V | | |
|---|---|---|---|---|---|---|---|---|---|
| Corresponding failed modules and insulation resistances | Measured phase (°) | Possible failed power modules | Resistance (kΩ) | Measured phase (°) | Possible failed power modules | Resistance(kΩ) | Measured phase (°) | Possible failed power modules | Resistance(kΩ) |
| | -73 | Cell_A3 | ~500 | -54 | Cell_A3 | ~130 | -50 | Cell_A3 | ~50 |
| | -78 | Cell_A2 | ~280 | -73 | Cell_A2 | ~100 | | | |
| | -85 | Cell_A1 | ~200 | | | | | | |

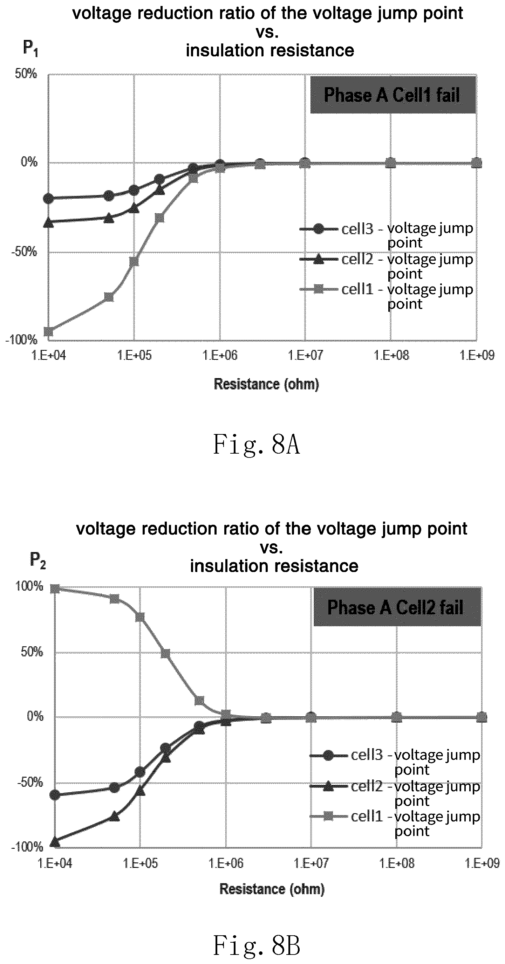

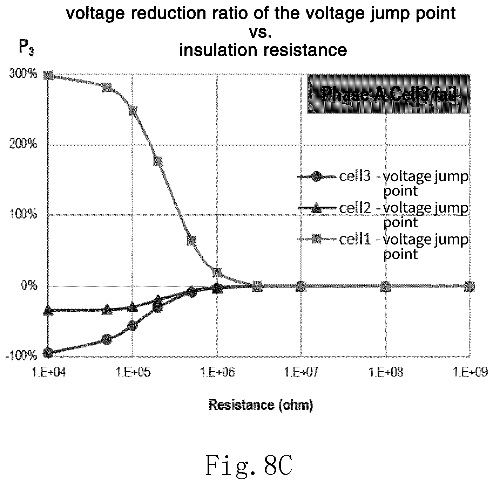

The determination method 1 shall measure the voltage amplitude and the phase of the power conversion circuit simultaneously. Relatively, the determination method 2 determines the cascaded position of the failed module only by measuring the voltage amplitude, which facilitates simplifying design of the insulation detection unit. FIGS. 8A to 8C are a change rule of a real-time voltage amplitude reduction ratio of the voltage jump points of the failed modules of the failure phases with decrease of the insulation resistances of the failed modules. As can be seen from the comparison figures 8A, 8B and 8C, the voltage amplitude reduction ratio of the corresponding voltage jump point of the failed module is the maximum, and the power module where the real-time voltage amplitude reduction ratio of the voltage jump point is the maximum is the power module where insulation failure occurs in the failure phase. Accordingly, the insulation failed module is located.

The determination method 2 has relative description of determination flows of the failed module in FIG. 5. In some embodiments of the application, the method for obtaining the voltage amplitudes of the voltage jump points of the failed modules of the failure phase is as follows: measuring and obtaining the voltage amplitude of the corresponding detection circuit of the failure phase, and calculating the voltage amplitudes of the voltage jump points of the failed modules. For example, in FIG. 4C, a voltage amplitude calculating method of the voltage jump point within the power module Cell_A2 is U_{ZA2}=U_{A}-(U_{PS_A22} +U_{PS_A31}+U_{PS_A32}), thereby reflecting the insulation state of the power module Cell_A2 relative to the reference point, wherein U_{ZA2} represents a voltage of the voltage jump point within the power module Cell_A2, U_{A} represents a voltage of the phase A detection circuit, U_{PS_A22} represents a voltage between the input end and the voltage jump point NA2 of the power module Cell_A2, U _{PS_A31} represents a voltage between the voltage jump point NA3 and the output end within Cell_A3, and U _{PS_A32} represents a voltage between the input end and the voltage jump point NA3 within Cell_A3.

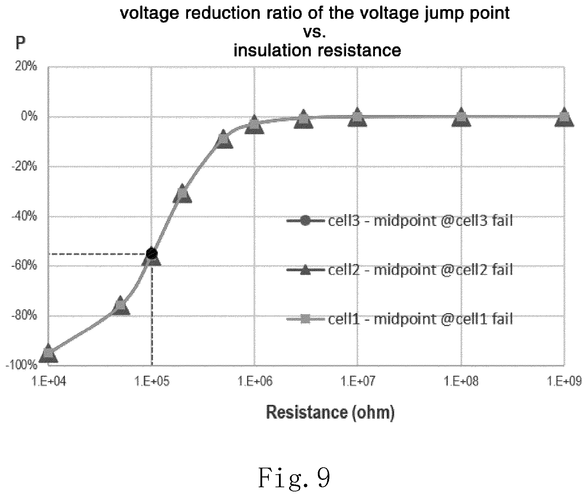

FIG. 9 shows a curve of a relation between the insulation resistance of the insulation failed module and the voltage amplitude reduction ratio of the voltage jump point of the failed module. As can be seen, the corresponding curves of different power modules coincide with each other, so the voltage amplitude reduction ratio of the voltage jump point is associated with the insulation resistance of the failed module, and irrelevant to the failed position. For example, when the voltage reduction ratio of one power module is 56%, the insulation resistance is 100kS2. Therefore, a third table is made accordingly, and the third table includes a mapping relation between the voltage amplitude reduction ratio of the voltage jump point and the insulation resistance of the failed module. In actual insulation detection process, the insulation detection unit obtain the insulation resistance of the failed module relative to the reference point by querying the third table according to the obtained voltage amplitude reduction ratio of the voltage jump point within the power module.

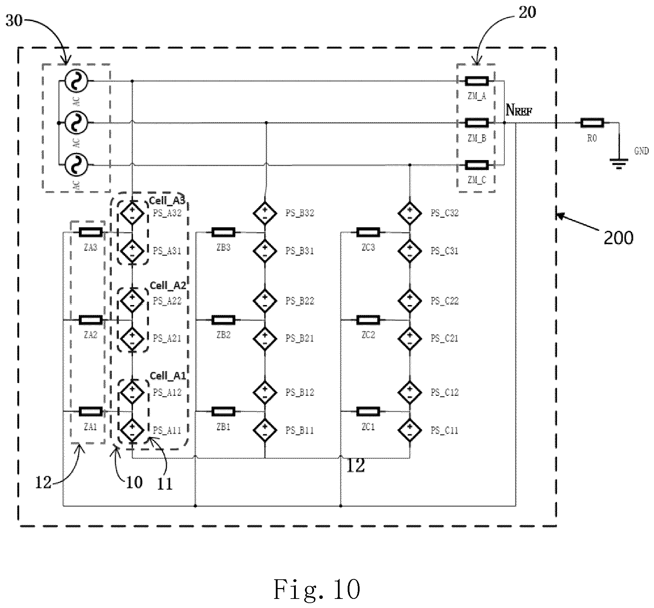

Embodiment three of the application, as shown in FIG. 10, shows a structure of grounding the reference point of the application via an impedance. In this embodiment, a second end of the detection circuit in the insulation detection circuit is electrically connected to one metal body via the reference point, the metal body is a metallic shield housing or a conductor/copper bar (the application is not limited thereto), and there is a certain impedance between the metal body and the ground. Various application scenarios such as vessel and aircraft is applicable.

Embodiment four of the application, as shown in FIGS. 11A to 11D, shows different signal sampling ways.

As shown in FIG. 11A, the real-time voltage of the voltage jump point within each power module is monitored, for example, monitoring the voltage U_{ZA2} of the voltage jump point within the power module Cell_A2, wherein U_{ZA2} represent a voltage at both ends of the insulation impedance ZA2 of the power module Cell_A2 relative to the reference point, thereby reflecting the insulation state of the voltage jump point within the power module Cell_A2 relative to the reference point. Such way is applicable to a circuit system having voltage monitoring function of the power conversion circuit itself, so as to facilitate further simplifying design of the circuit.

As shown in FIG. 11B, it shows a structure of a voltage-dividing detection circuit. For example, a voltage-dividing detection circuit is formed by a plurality of detection impedances ZM_1, ZM_2, ZM_3 and ZM_4, a voltage of the corresponding detection circuit is measured through the voltage-dividing detection circuit, and a voltage class of a measurement signal processing circuit is reduced.

As shown in FIG. 11C, it shows a structure of another detection circuit, and a difference from the detection circuit of FIG. 11B is that the detection circuit of this embodiment further includes a transformer Tm. A primary winding of the transformer Tm is connected in parallel to at least a part of detection impedances, and a voltage of the corresponding detection circuit is measured through a secondary winding of the transformer Tm. In this embodiment, electrical isolation measurement is achieved through the transformer Tm, and a safety class of a low-voltage circuit is improved.

As shown in FIG. 11D, it shows another alternative detection way, and a difference from the method in that FIG. 12D directly measures and obtains a current value Im within the detection circuit using a current probe, and indirectly calculates and obtains a real-time voltage of the detection circuit combining with the detection impedance of the detection circuit.

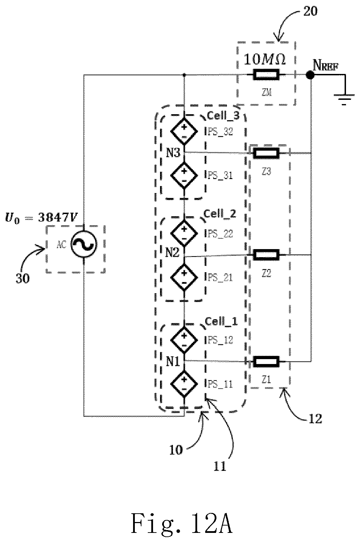

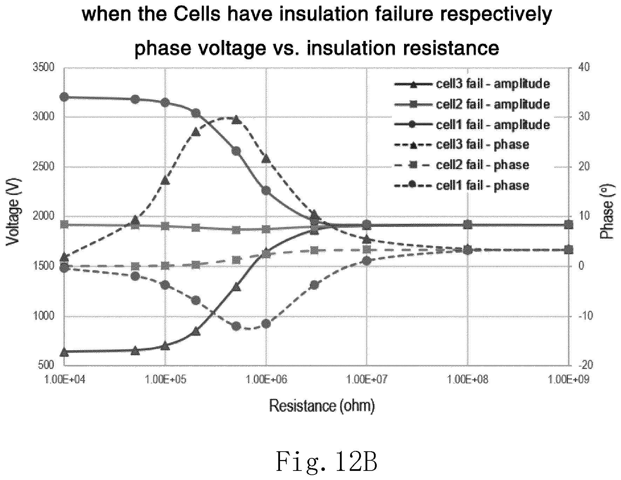

Embodiment five of the application is determination of the insulation failed module of the single phase system. FIG. 12A shows a circuit model of the insulation detection circuit based on the single phase system according to the application, and FIG. 12B shows curves of phase voltages when different power modules are in insulation failure state. As stated previously, in this embodiment, the location and the corresponding insulation resistance of the failed module is obtained by querying the first table according to the measured voltage amplitude and phase of the detection circuit 20.

In the application, if the number of cascaded power modules is odd, when the power module at a middle position is in insulation failure state, a voltage change of the corresponding detection circuit is not obvious. When the three power modules (i.e., Cell_1 to Cell_3) in FIG. 12A are cascaded, if Cell_2 is in insulation failure state, the maximum change of the voltage amplitude of the detection circuit 20 is 50V, the change is relatively small, and does not facilitate the insulation detection unit to determine. The application increase a change of the phase voltages with insulation failure of the power module at the middle position when the number of the cascaded power modules is an odd number through the following two methods, thereby increasing sensitivity of measurement, and these methods are applicable to the single phase system, and also applicable to the three-phase system.

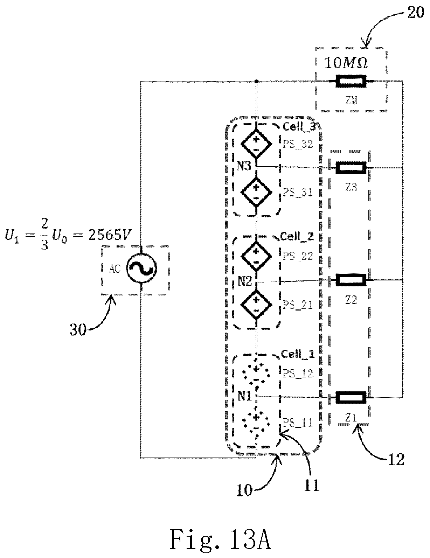

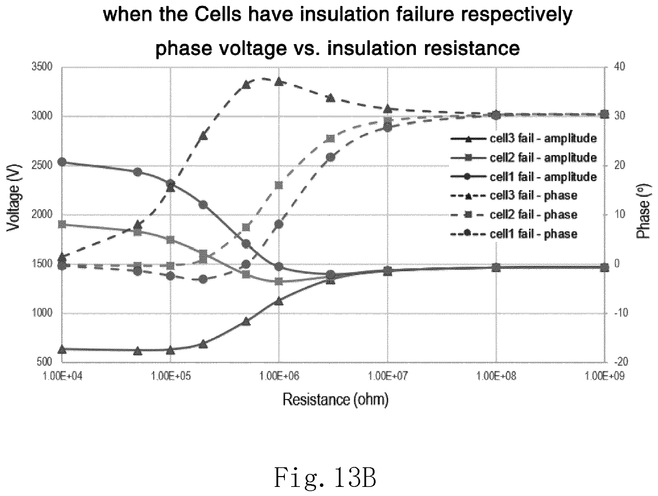

First method: one power module (e.g., Cell_1 at the lowest end position of FIG. 13A) is bypassed to form an even-numbered power modules cascaded, and the power module at the end portion is bypassed. Here at the end portion represents that the position of the power module in the power conversion circuit is at the head or tail of the cascade connection. For example, in the topology of FIG. 13A, after the power module Cell_1 at the lowest end position is bypassed, as can be seen from FIG. 13B, when Cell_2 is in insulation failure state, a voltage change range of the detection circuit 20 is increased to 500V. However, the problem of such method is that the bypassed power module cannot be detected, so in the actual detection process, different power modules are alternatively bypassed to achieve insulation detection of each power module. For example, in the topology of FIG. 13A, after the power module Cell_1 is firstly bypassed, the power module Cell_2 and the power module Cell_3 are detected, secondly, after the power module Cell_2 is bypassed, the power module Cell_1 and the power module Cell_3 are detected, and thirdly, after the power module Cell_3 is bypassed, the power module Cell_1 and the power module Cell_2 are detected. In such way, it is possible to achieve detection of each power module, and a time interval between each bypass can be two hours. The specific time interval is not limited, and can be set according to actual needs.

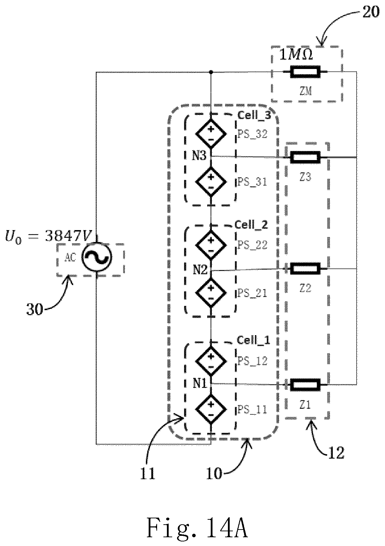

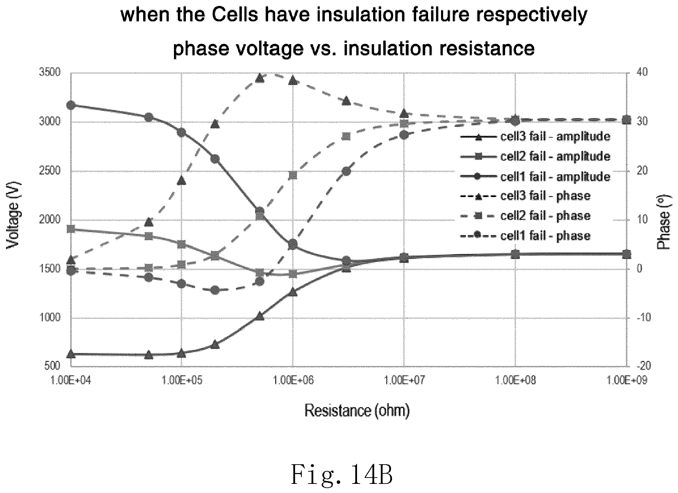

Second method: a resistance of the detection impedance is reduced. For example, a resistance of the detection impedance ZM is reduced from 10MQ of FIG. 13A to 1MΩ of FIG. 14A, and FIG. 14B shows a change of phase voltages along with the insulation resistances when different power modules are in insulation failure state. As can be seen from FIG. 14B, when the power module Cell_2 is in insulation failure state, a phase voltage change range is increased to 550V.

Embodiment six of the application, as shown in FIG. 15, shows a topological deformation of the insulation detection circuit based on the three-phase system according to the application. The three input power source 30 and the three power conversion circuits 10 (phase A, phase B and phase C) are all in star connection, and neutral points are electrically connected. As shown in FIG. 15, the first neutral point N_{M1} and the second neutral point N_{M2} are electrically connected.

Embodiment seven of the application, as shown in FIG. 16, shows a topological deformation according to the application. A power detection impedance ZMs connected in parallel to the input power source 30 is added, such that the insulation detection unit detect a power supply voltage and a voltage of the detection circuit 20 simultaneously. In this embodiment, influence of fluctuation of the power supply voltage on measurement of the detection circuit 20 is excluded through detection of the power supply voltage. For example, before determining insulation state, firstly, whether the input power source 30 has fault can be determined, and when the insulation detection unit detects and determines that the real-time voltage amplitude of the power detection impedance is less than a threshold, for example, the real-time voltage amplitude of the power detection impedance is less than 95% of the maximum voltage amplitude of the power detection impedance, it can be considered that the input power source30 has fault. In actual detection process, it is necessary to determine whether the input power source 30 has fault, and after ensuring the input power source 30 to be normal, accuracy of the insulation detection is ensured. Here 95% of the maximum voltage amplitude of the power detection impedance is a second voltage threshold. In the application, obtaining the detection voltage or other signals, comparing between the signals and determining the insulation state are performed by the insulation detection unit.

According to some embodiments of the application, the application provides some insulation detection methods through the insulation detection circuit.

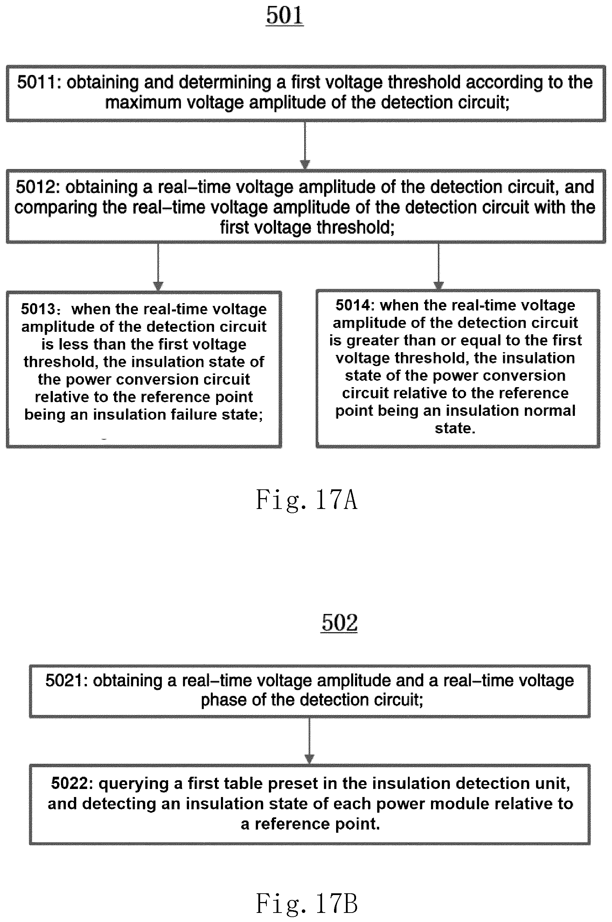

As shown in FIG. 17A, the application provides an insulation detection method 501, which is applied to, for example, including but not limited to an insulation detection circuit 100-1 of FIG. 2 for detecting an insulation state of the power conversion circuit 10 relative to a reference point N_{REF}, and the reference point N_{REF} is grounded. The insulation detection method 501 includes:
5011: obtaining and determining a first voltage threshold according to the maximum voltage amplitude of the detection circuit 20;
5012: obtaining a real-time voltage amplitude of the detection circuit 20, and comparing the real-time voltage amplitude of the detection circuit 20 with the first voltage threshold;
5013: when the real-time voltage amplitude of the detection circuit 20 is less than the first voltage threshold, the insulation state of the power conversion circuit 10 relative to the reference point N_{REF} being an insulation failure state; and
5014: when the real-time voltage amplitude of the detection circuit 20 is greater than or equal to the first voltage threshold, the insulation state of the power conversion circuit 10 relative to the reference point N_{REF} being an insulation normal state.

In general, the maximum voltage amplitude of the detection circuit is equal to the maximum voltage amplitude of the input power source. Here the first voltage threshold can be set to be 95% of the maximum voltage amplitude of the detection circuit, and a specific size of the first voltage threshold is determined according to actual needs.

In some embodiments of the application, as for including but not limited to, for example, an insulation detection circuit 100-3 of FIG. 16, the insulation detection method 501 is further include:
obtaining and determining a second voltage threshold according to the maximum voltage amplitude of the power detection impedance ZMs connected in parallel to the input power source 30;
obtaining a real-time voltage amplitude of the power detection impedance ZMs, and comparing the real-time voltage amplitude of the power detection impedance ZMs with the second voltage threshold;
when the real-time voltage amplitude of the power detection impedance ZMs is less than the second voltage threshold, the input power source 30 being in a failure state; and
when the real-time voltage amplitude of the power detection impedance ZMs is greater than or equal to the second voltage threshold, the input power source 30 being in a normal state.

The second voltage threshold, for example, is 95% of the maximum voltage amplitude of the power detection impedance, but it can be understood that the application is not limited thereto. In actual insulation detection process, it is necessary to determine whether the input power source 30 has fault, and after ensuring the input power source 30 to be normal, accuracy of the insulation detection is ensured.

In some embodiments of the application, as for including but not limited to, for example, the insulation detection circuit 100-1 of FIG. 2, when the power conversion circuit 10 includes odd-numbered power modules 11 connected in series, the insulation detection method 501 further includes: bypassing one of the power modules 11 or reducing the detection impedance ZM within the detection circuit 20. In such way, sensitivity of detection can be further increased.

In some embodiments, the bypassed power modules are at an end position close to the head or tail of the odd-numbered power modules connected in series.

As shown in FIG. 17B, the application further provides an insulation detection method 502, which is applied to, for example, including but not limited to the insulation detection circuit 100-1 of FIG. 2 for detecting an insulation state of each power module 11 in the power conversion circuit 10 relative to the reference point N_{REF}. The insulation detection method 502 includes:
5021: obtaining a real-time voltage amplitude and a real-time voltage phase of the detection circuit 20;
5022: querying a first table preset in the insulation detection unit, and detecting an insulation state of each power module 11 relative to a reference point.

The first table includes a correspondence relation between the voltage amplitude and the voltage phase of the detection circuit 20 and a cascaded position of the power module 11 where insulation failure occurs.

In some embodiments of the application, the first table further includes a corresponding insulation resistance when each power module 11 in the power conversion circuit 10 is in insulation failure state relative to the reference point. The insulation detection method 502 further includes: querying a first table, and obtaining an insulation resistance of the power module 11 where insulation failure occurs relative to the reference point.

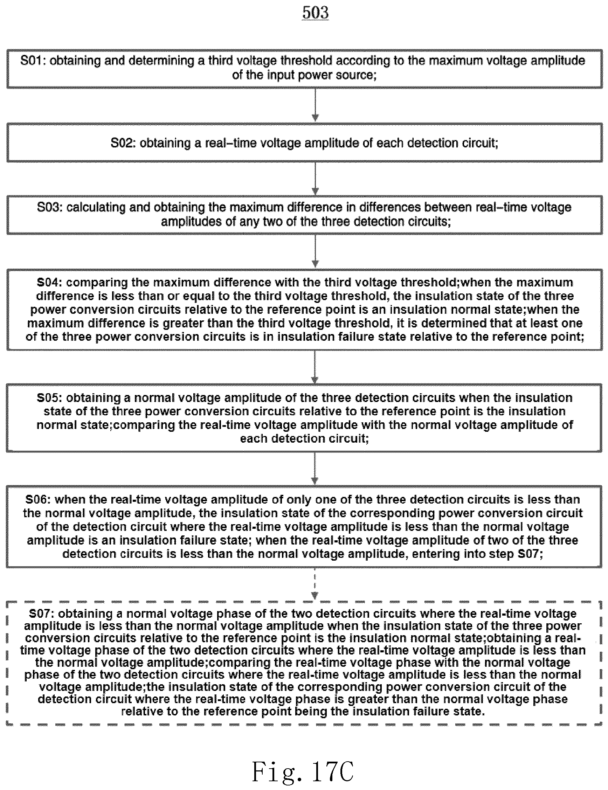

As shown in FIG. 17C, the application further provides an insulation detection method 503, which is applied to, for example, including but not limited to the insulation detection circuit 100-2 of FIG. 4C for detecting an insulation state of each power conversion circuit 10 relative to the reference point N_{REF}. The insulation detection method 503 includes:
S01: obtaining and determining a third voltage threshold according to the maximum voltage amplitude of the input power source;
S02: obtaining a real-time voltage amplitude of each detection circuit;
S03: calculating and obtaining the maximum difference in differences between real-time voltage amplitudes of any two of the three detection circuits;
S04: comparing the maximum difference with the third voltage threshold.

When the maximum difference is less than or equal to the third voltage threshold, the insulation state of the three power conversion circuits relative to the reference point is an insulation normal state.

When the maximum difference is greater than the third voltage threshold, it is determined that at least one of the three power conversion circuits is in insulation failure state relative to the reference point.

Further, in order to determine the specific power conversion circuit where insulation failure occurs in the three-phase system, the method further includes:
S05: obtaining a normal voltage amplitude of the three detection circuits when the insulation state of the three power conversion circuits relative to the reference point is the insulation normal state;
comparing the real-time voltage amplitude with the normal voltage amplitude of each detection circuit;
S06: when the real-time voltage amplitude of only one of the three detection circuits is less than the normal voltage amplitude, the insulation state of the corresponding power conversion circuit of the detection circuit where the real-time voltage amplitude is less than the normal voltage amplitude is an insulation failure state; when the real-time voltage amplitude of two of the three detection circuits is less than the normal voltage amplitude, entering into step S07;
S07: obtaining a normal voltage phase of the two detection circuits where the real-time voltage amplitude is less than the normal voltage amplitude when the insulation state of the three power conversion circuits relative to the reference point is the insulation normal state;
obtaining a real-time voltage phase of the two detection circuits where the real-time voltage amplitude is less than the normal voltage amplitude;
comparing the real-time voltage phase with the normal voltage phase of the two detection circuits where the real-time voltage amplitude is less than the normal voltage amplitude;
the insulation state of the corresponding power conversion circuit of the detection circuit where the real-time voltage phase is greater than the normal voltage phase relative to the reference point being the insulation failure state.

The third voltage threshold is 5% of the maximum voltage amplitude of the input power source, but it can be understood that the application is not limited thereto.

In some embodiments of the application, the method for obtaining the maximum voltage amplitude of the input power source includes: obtaining and calculating the maximum voltage amplitude of each input power source according to the real-time voltage amplitude and the real-time voltage phase of the three detection circuits.

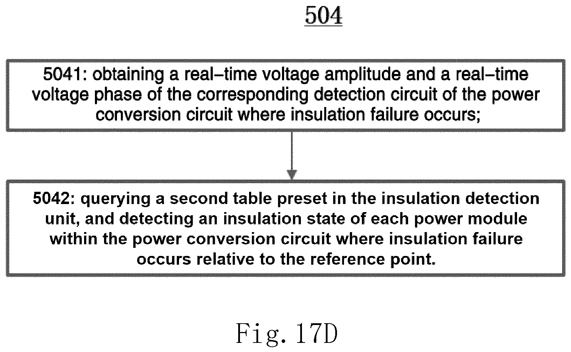

As shown in FIG. 17D, the application further provides an insulation detection method 504, which ise applied to, for example, including but not limited to the insulation detection circuit 100-2 of FIG. 4C, and at least one of the three power conversion circuits 10 of the insulation detection circuit 100-2 includes a plurality of power modules 11 connected in series. When the power conversion circuit including a plurality of power modules is in insulation failure state, the insulation detection method 504 is configured to detect an insulation state of each power module within the power conversion circuit where insulation failure occurs relative to the reference point N_{REF}. The insulation detection method 504 includes:
5041: obtaining a real-time voltage amplitude and a real-time voltage phase of the corresponding detection circuit of the power conversion circuit where insulation failure occurs;
5042: querying a second table preset in the insulation detection unit, and detecting an insulation state of each power module within the power conversion circuit where insulation failure occurs relative to the reference point.

The second table includes a correspondence relation between the voltage amplitudes and phases of the power conversion circuits 10 (such as, phases of the three-phase system) and a cascaded position of the power module where insulation failure occurs, for example, table 1.

In some embodiments of the application, the second table further includes a corresponding insulation resistance when each power module within the power conversion circuit where insulation failure occurs is in insulation failure state relative to the reference point, for example, table 1. The insulation detection method 504 further includes: querying a second table, and obtaining an insulation resistance of the power module where insulation failure occurs relative to the reference point.

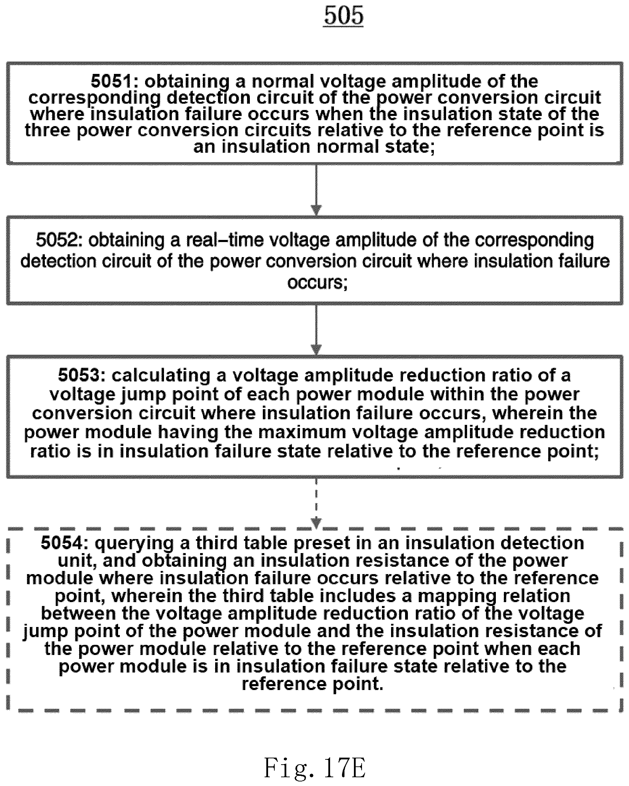

As shown in FIG. 17E, the application further provides an insulation detection method 505, which is applied to, for example, including but not limited to the insulation detection circuit 100-2 of FIG. 4C, and at least one of the three power conversion circuits of the insulation detection circuit 100-2 includes a plurality of power modules connected in series. When the power conversion circuit including a plurality of power modules is in insulation failure state, the insulation detection method 505 is configured to detect an insulation state of each power module within the power conversion circuit where insulation failure occurs relative to the reference point. The insulation detection method 505 includes:
5051: obtaining a normal voltage amplitude of the corresponding detection circuit of the power conversion circuit where insulation failure occurs when the insulation state of the three power conversion circuits relative to the reference point is an insulation normal state;
5052: obtaining a real-time voltage amplitude of the corresponding detection circuit of the power conversion circuit where insulation failure occurs;
5053: calculating a voltage amplitude reduction ratio of a voltage jump point of each power module within the power conversion circuit where insulation failure occurs, wherein the power module having the maximum voltage amplitude reduction ratio is in insulation failure state relative to the reference point.

In some embodiments of the application, the insulation detection method 505 further includes:
5054: querying a third table preset in an insulation detection unit, and obtaining an insulation resistance of the power module where insulation failure occurs relative to the reference point, wherein the third table includes a mapping relation between the voltage amplitude reduction ratio of the voltage jump point of the power module and the insulation resistance of the power module relative to the reference point when each power module is in insulation failure state relative to the reference point.

In conclusion, through the insulation detection circuit and the insulation detection method of the application, it is unnecessary to additionally add a measuring device, and can also sensitively reflect or monitor the insulation state of each power module. In some embodiments, through the application, position of the failed module and information of the insulation resistance (including but not limited to the insulation resistance) are obtained.

The exemplary embodiments of the application are illustrated and described in details. It shall be understood that the application is not limited to the disclosed embodiments. In contrast, the application intends to cover various modifications and equivalent arrangements included in spirit and scope of the appended claims.

## Claims

1. An insulation detection circuit (100-1, 100-2), **characterized in that**, comprising:
a power conversion circuit (10) comprising a power module (11), the power module (11) comprising an input end, an output end and a voltage jump point (N1, N2, N3; NA1, NA2, NA3, NB1, NB2, NB3; NC1, NC2, NC3);
a detection circuit (20) comprising a detection impedance, a first end of the detection circuit (20) electrically connected to the input end or the output end of the power module (11), a second end of the detection circuit (20) electrically connected to a reference point (N_{REF});
an input power source (30) electrically connected to the power conversion circuit (10); and
an insulation detection unit for obtaining a voltage or a current of the detection circuit (20), and detecting an insulation state of the power conversion circuit (10) relative to the reference point (N_{REF}), or detecting an insulation state of the voltage jump point (N1, N2, N3; NA1, NA2, NA3, NB1, NB2, NB3; NC1, NC2, NC3) of the power module (11) relative to the reference point (N_{REF}).

2. The insulation detection circuit (100-1, 100-2) according to claim 1, wherein the voltage jump point (N1, N2, N3; NA1, NA2, NA3, NB1, NB2, NB3; NC1, NC2, NC3) is a conductive layer or a semiconductive layer located at an inner side of an insulation housing of the power module (11).

3. The insulation detection circuit (100-1, 100-2) according to claim 1, wherein,
the power conversion circuit (10) comprises a plurality of the power modules (11) connected in series, the first end of the detection circuit (20) is electrically connected to one of the input end, the output end and the voltage jump point (N1, N2, N3; NA1, NA2, NA3, NB1, NB2, NB3; NC1, NC2, NC3) of one of the plurality of the power modules (11).

4. The insulation detection circuit (100-1, 100-2) according to claim 1, comprising:
three of the power conversion circuits (10), one end of each one of the three power conversion circuits (10) being electrically connected to a first neutral point (N_{M1});
three of the detection circuits (20) in one-to-one correspondence with the three power conversion circuits (10), the first end of each one of the three detection circuits (20) being electrically connected to the input end or the output end of one of the power modules (11) within the corresponding power conversion circuit (10), and the second end of each one of the three detection circuits (20) being electrically connected to the reference point (N_{REF}); and
three of the input power sources (30), one end of each one of the three input power sources (30) being electrically connected to a second neutral point (N_{M2}), and the other end of each one of the three input power sources (30) being electrically connected to the other end of each one of the three power conversion circuits (10), respectively;
wherein the first neutral point (N_{M1}) and the second neutral point are electrically connected.

5. An insulation detection method, **characterized in that**, applied to the insulation detection circuit (100-1, 100-2) according to claim 1, the insulation detection method configured for detecting the insulation state of the power conversion circuit (10) relative to the reference point (N_{REF}),
the insulation detection method comprising:
determining a first voltage threshold according to the maximum voltage amplitude of the detection circuit (20);
obtaining a real-time voltage amplitude of the detection circuit (20);
comparing the real-time voltage amplitude of the detection circuit (20) with the first voltage threshold;
when the real-time voltage amplitude of the detection circuit (20) is less than the first voltage threshold, determining that the insulation state of the power conversion circuit (10) relative to the reference point (N_{REF}) is an insulation failure state;
when the real-time voltage amplitude of the detection circuit (20) is greater than or equal to the first voltage threshold, determining that the insulation state of the power conversion circuit (10) relative to the reference point (N_{REF}) is an insulation normal state.

6. The insulation detection method according to claim 5, wherein the first voltage threshold is 95% of the maximum voltage amplitude of the detection circuit (20).

7. The insulation detection method according to claim 5, further comprising:
determining a second voltage threshold according to a maximum voltage amplitude of a power detection impedance connected in parallel to the input power source (30);
obtaining a real-time voltage amplitude of the power detection impedance;
comparing the real-time voltage amplitude of the power detection impedance with the second voltage threshold;
when the real-time voltage amplitude of the power detection impedance is less than the second voltage threshold, determining that the input power source (30) is in a failure state;
when the real-time voltage amplitude of the power detection impedance is greater than or equal to the second voltage threshold, determining that the input power source (30) is in a normal state;
wherein the second voltage threshold is 95% of the maximum voltage amplitude of the power detection impedance.

8. The insulation detection method according to claim 5, wherein the power conversion circuit (10) comprises odd number of the power modules (11) connected in series, and the insulation detection method further comprises:
bypassing one of the odd-numbered power modules (11) or reducing the detection impedance within the detection circuit (20).

9. The insulation detection method according to claim 8, wherein the one of the odd-numbered power modules (11) being bypassed is located at an end position of the series connection of the odd-numbered power modules (11).

10. An insulation detection method, **characterized in that**, applied to the insulation detection circuit (100-1, 100-2) according to claim 3, the insulation detection method configured for detecting the insulation state of the voltage jump point (N1, N2, N3; NA1, NA2, NA3, NB1, NB2, NB3; NC1, NC2, NC3) of each one of the plurality of the power modules relative to the reference point (N_{REF}),
the insulation detection method comprising:
obtaining a real-time voltage amplitude of the detection circuit (20) and a real-time voltage phase of the detection circuit (20);
querying a first table preset in the insulation detection unit, determining the insulation state of the voltage jump point (N1, N2, N3; NA1, NA2, NA3, NB1, NB2, NB3; NC1, NC2, NC3) of each one of the plurality of the power modules relative to the reference point (N_{REF}).

11. The insulation detection method according to claim 10, wherein,
the first table comprises an insulation resistance corresponding to the voltage jump point (N1, N2, N3; NA1, NA2, NA3, NB1, NB2, NB3; NC1, NC2, NC3) of each one of the plurality of the power modules being in an insulation failure state relative to the reference point (N_{REF});
the insulation detection method further comprises:
querying the first table, and obtaining the insulation resistance between the voltage jump point (N1, N2, N3; NA1, NA2, NA3, NB1, NB2, NB3; NC1, NC2, NC3) of the power module (11) being in the insulation failure state relative to the reference point (N_{REF}) and the reference point (N_{REF}).

12. An insulation detection method, **characterized in that**, applied to the insulation detection circuit (100-1, 100-2) according to claim 4, the insulation detection method configured for detecting the insulation state of the three power conversion circuits (10) relative to the reference point (N_{REF}),
the insulation detection comprising:
determining a third voltage threshold according to a maximum voltage amplitude of the three input power sources (30);
obtaining a real-time voltage amplitude of each one of the three detection circuits (20);
obtaining a maximum difference in differences between the real-time voltage amplitudes of two of the three detection circuits (20);
comparing the maximum difference with the third voltage threshold;
when the maximum difference is less than or equal to the third voltage threshold, determining that the insulation state of each one of the three power conversion circuits (10) relative to the reference point (N_{REF}) is an insulation normal state;
when the maximum difference is greater than the third voltage threshold, determining that the insulation state of at least one of the three power conversion circuits (10) relative to the reference point (N_{REF}) is an insulation failure state.

13. The insulation detection method according to claim 12, wherein,
the step of when the maximum difference is greater than the third voltage threshold, determining that the insulation state of at least one of the three power conversion circuits (10) relative to the reference point (N_{REF}) is an insulation failure state comprises:
obtaining a normal voltage amplitude of each one of the three detection circuits (20) when the insulation state of the three power conversion circuits (10) relative to the reference point (N_{REF}) is the insulation normal state;
comparing the real-time voltage amplitude of each one of the three detection circuits (20) with the normal voltage amplitude of each one of the three detection circuits (20);
when the real-time voltage amplitude of only one of the three detection circuits (20) is less than the normal voltage amplitude of the only one of the three detection circuits (20), the insulation state of the power conversion circuit (10) corresponding to the only one of the three detection circuits (20) relative to the reference point (N_{REF}) being the insulation failure state.

14. The insulation detection method according to claim 12, wherein,
the step of when the maximum difference is greater than the third voltage threshold, determining that the insulation state of at least one of the three power conversion circuits (10) relative to the reference point (N_{REF}) is an insulation failure state comprises:
obtaining a normal voltage amplitude of each one of the three detection circuits (20) when the insulation state of the three power conversion circuits (10) relative to the reference point (N_{REF}) is the insulation normal state;
comparing the real-time voltage amplitude of each one of the three detection circuits (20) with the normal voltage amplitude of each one of the three detection circuits (20);
when the real-time voltage amplitude of each one of two of the three detection circuits (20) is less than the normal voltage amplitude of each one of the two of the three detection circuits (20), obtaining a normal voltage phase of each one of the two of the three detection circuits (20) when the insulation state of the three power conversion circuits (10) relative to the reference point (N_{REF}) is the insulation normal state;
obtaining a real-time voltage phase of each one of the two of the three detection circuits (20);
comparing the real-time voltage phase of the two of the three detection circuits (20) with the normal voltage phase of the two of the three detection circuits (20);
when the real-time voltage phase of one of the two of the three detection circuits (20) is greater than the normal voltage phase of the one of the two of the three detection circuits (20), determining that the insulation state of the power conversion circuit (10) corresponding to the one of the two of the three detection circuits (20) is the insulation failure state.

15. The insulation detection method according to claim 12, wherein the third voltage threshold is 5% of the maximum voltage amplitude of the three input power sources (30).

16. An insulation detection method, **characterized in that**, applied to the insulation detection circuit (100-1, 100-2) according to claim 4, at least one of the three power conversion circuits (10) comprises a plurality of the power modules connected in series;
when the insulation state of the at least one of the three power conversion circuits (10) relative to the reference point (N_{REF}) is an insulation failure state, the insulation detection method configured for detecting the insulation state of the voltage jump point (N1, N2, N3; NA1, NA2, NA3, NB1, NB2, NB3; NC1, NC2, NC3) of each one of the plurality of the power modules within the at least one of the three power conversion circuits (10) relative to the reference point (N_{REF}),
the insulation detection method comprising:
obtaining a real-time voltage amplitude and a real-time voltage phase of the detection circuit (20) corresponding to the at least one of the three power conversion circuits (10);
querying a second table preset in the insulation detection unit, determining the insulation state of the voltage jump point (N1, N2, N3; NA1, NA2, NA3, NB1, NB2, NB3; NC1, NC2, NC3) of each one of the plurality of the power modules within the at least one of the three power conversion circuits (10) relative to the reference point (N_{REF}).

17. The insulation detection method according to claim 16, wherein,
the second table comprises an insulation resistance corresponding to the voltage jump point (N1, N2, N3; NA1, NA2, NA3, NB1, NB2, NB3; NC1, NC2, NC3) of each one of the plurality of power modules being in the insulation failure state relative to the reference point (N_{REF});
the insulation detection method further comprises:
querying the second table, and obtaining the insulation resistance between the voltage jump point (N1, N2, N3; NA1, NA2, NA3, NB1, NB2, NB3; NC1, NC2, NC3) of the power module (11) being in the insulation failure state relative to the reference point (N_{REF}) and the reference point (N_{REF}).

18. An insulation detection method, **characterized in that**, applied to the insulation detection circuit (100-1, 100-2) according to claim 4, and at least one of the three power conversion circuits (10) comprises a plurality of the power modules connected in series;
when the insulation state of the at least one of the three power conversion circuits (10) relative to the reference point (N_{REF}) is an insulation failure state, the insulation detection method configured for detecting the insulation state of the voltage jump point (N1, N2, N3; NA1, NA2, NA3, NB1, NB2, NB3; NC1, NC2, NC3) of each one of the plurality of the power modules within the at least one of the three power conversion circuits (10) relative to the reference point (N_{REF}),
the insulation detection method comprising:
obtaining a normal voltage amplitude of the voltage jump point (N1, N2, N3; NA1, NA2, NA3, NB1, NB2, NB3; NC1, NC2, NC3) of each one of the plurality of the power modules within the at least one of the three power conversion circuits (10) when the insulation state of the three power conversion circuits (10) relative to the reference point (N_{REF}) is an insulation normal state;
obtaining a real-time voltage amplitude of the voltage jump point (N1, N2, N3; NA1, NA2, NA3, NB1, NB2, NB3; NC1, NC2, NC3) of each one of the plurality of the power modules within the at least one of the three power conversion circuits (10);
calculating a voltage amplitude reduction ratio of the voltage jump point (N1, N2, N3; NA1, NA2, NA3, NB1, NB2, NB3; NC1, NC2, NC3) of each one of the plurality of the power modules within the at least one of the three power conversion circuits (10), wherein the voltage jump point (N1, N2, N3; NA1, NA2, NA3, NB1, NB2, NB3; NC1, NC2, NC3) of the power module (11) corresponding to the maximum voltage amplitude reduction ratio is in the insulation failure state relative to the reference point (N_{REF}).

19. The insulation detection method according to claim 18, wherein the step of obtaining a normal voltage amplitude of the voltage jump point (N1, N2, N3; NA1, NA2, NA3, NB1, NB2, NB3; NC1, NC2, NC3) of each one of the plurality of the power modules within the at least one of the three power conversion circuits (10) when the insulation state of the three power conversion circuits (10) relative to the reference point (N_{REF}) is an insulation normal state comprises:
when the insulation state of the three power conversion circuits (10) relative to the reference point (N_{REF}) is the insulation normal state, obtaining a normal voltage amplitude of the detection circuit (20) corresponding to the at least one of the three power conversion circuits (10);
obtaining a voltage difference between the other end of the at least one of the three power conversion circuits (10) and the voltage jump point (N1, N2, N3; NA1, NA2, NA3, NB1, NB2, NB3; NC1, NC2, NC3) of each one of the plurality of the power modules within the at least one of the three power conversion circuits (10);
the normal voltage amplitude of the voltage jump point (N1, N2, N3; NA1, NA2, NA3, NB1, NB2, NB3; NC1, NC2, NC3) of each one of the plurality of the power modules being the normal voltage amplitude of the detection circuit (20) corresponding to the at least one of the three power conversion circuits (10) subtracting the voltage difference;
the step of obtaining a real-time voltage amplitude of the voltage jump point (N1, N2, N3; NA1, NA2, NA3, NB1, NB2, NB3; NC1, NC2, NC3) of each one of the plurality of the power modules within the at least one of the three power conversion circuits (10) comprises:
obtaining a real-time voltage amplitude of the detection circuit (20) corresponding to the at least one of the three power conversion circuits (10);
obtaining the voltage difference between the other end of the at least one of the three power conversion circuits (10) and the voltage jump point (N1, N2, N3; NA1, NA2, NA3, NB1, NB2, NB3; NC1, NC2, NC3) of each one of the plurality of the power modules within the at least one of the three power conversion circuits (10); the real-time voltage amplitude of the voltage jump point (N1, N2, N3; NA1, NA2, NA3, NB1, NB2, NB3; NC1, NC2, NC3) of each one of the plurality of the power modules being the real-time voltage amplitude of the detection corresponding to the at least one of the three power conversion circuits (10) subtracting the voltage difference.

20. The insulation detection method according to claim 18, wherein the insulation detection method further comprises:
querying a third table preset in the insulation detection unit, obtaining an insulation resistance of the power module (11) being in the insulation failure state relative to the reference point (N_{REF});
wherein the third table comprises a mapping relation between the voltage amplitude reduction ratio of the voltage jump point (N1, N2, N3; NA1, NA2, NA3, NB1, NB2, NB3; NC1, NC2, NC3) of the power module (11) and the insulation resistance between the voltage jump point (N1, N2, N3; NA1, NA2, NA3, NB1, NB2, NB3; NC1, NC2, NC3) of the power module (11) relative to the reference point (N_{REF}) and the reference point (N_{REF}) when the voltage jump point (N1, N2, N3; NA1, NA2, NA3, NB1, NB2, NB3; NC1, NC2, NC3) of each one of the polarity of the power module (11) being in the insulation failure state relative to the reference point (N_{REF}).
